(19)

Europäisches
Patentamt

European
Patent Office

Office européen
des brevets

(11) **EP 4 531 286 A1**

(12) **EUROPEAN PATENT APPLICATION**
published in accordance with Art. 153(4) EPC

(43) Date of publication:
**02.04.2025 Bulletin 2025/14**

(21) Application number: **23823192.2**

(22) Date of filing: **14.06.2023**

(51) International Patent Classification (IPC):
***H03M 13/11*** *(2006.01)*

(52) Cooperative Patent Classification (CPC):
**H03M 13/11**

(86) International application number:
**PCT/CN2023/100206**

(87) International publication number:
**WO 2023/241626 (21.12.2023 Gazette 2023/51)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **18.06.2022 CN 202210688993**

(71) Applicant: **Huawei Technologies Co., Ltd.
Shenzhen, Guangdong 518129 (CN)**

(72) Inventors:
- **MONTORSI, Guido
  10131 Torino (IT)**
- **BENEDETTO, Sergio
  10122 Torino (IT)**
- **LIN, Wei
  Shenzhen, Guangdong 518129 (CN)**
- **YANG, Xun
  Shenzhen, Guangdong 518129 (CN)**
- **XIN, Yan
  Shenzhen, Guangdong 518129 (CN)**
- **GAN, Ming
  Shenzhen, Guangdong 518129 (CN)**
- **MA, Mengyao
  Shenzhen, Guangdong 518129 (CN)**

(74) Representative: **Goddar, Heinz J.
Boehmert & Boehmert
Anwaltspartnerschaft mbB
Pettenkoferstrasse 22
80336 München (DE)**

(54) **LDPC ENCODING METHOD, LDPC DECODING METHOD, AND RELATED APPARATUS**

(57)     This application discloses an LDPC encoding method, an LDPC decoding method, and a related apparatus. This application is applied to a wireless local area network system supporting 802.11 series protocols such as an IEEE 802.11ax next-generation Wi-Fi protocol and Wi-Fi 8, and may also be applied to a UWB-based wireless personal area network system. The method includes: performing low-density parity-check LDPC encoding on a first bit sequence based on a parity check matrix to obtain a first data packet, where the parity check matrix includes a first parity check matrix and a second parity check matrix, both the first parity check matrix and the second parity check matrix conform to a first base matrix, and a code length of the first parity check matrix is different from a code length of the second parity check matrix; and sending the first data packet. The first parity check matrix and the second parity check matrix are obtained by extending the same base matrix, namely, the first base matrix, so that encoding complexity can be reduced.

FIG. 8

**Description**

This application claims priority to Chinese Patent Application No. 202210688993.0, filed with the China National Intellectual Property Administration on June 18, 2022 and entitled "LDPC ENCODING METHOD, LDPC DECODING METHOD, AND RELATED APPARATUS", which is incorporated herein by reference in its entirety.

**TECHNICAL FIELD**

This application relates to the field of communication technologies, and in particular, to an LDPC encoding method, an LDPC decoding method, and a related apparatus.

**BACKGROUND**

A wireless local area network (wireless local area network, WLAN) transmission standard like IEEE 802.11n/ac/ax/be mainly aims at improving user experience in a high-bandwidth scenario, including improving an average user throughput and energy usage efficiency of a battery-type power supply device. In a 60 GHz high-bandwidth scenario, high-speed and reliable transmission of services such as data and video on limited frequency and power resources needs to be supported. Therefore, a highly reliable and efficient channel encoding/decoding scheme is required. In the field of channel encoding, a Turbo code and a low-density parity-check (low-density parity-check, LDPC) code are two maturest and widely used channel encoding methods currently, and both the two codes have performance close to a Shannon (Shannon) limit. Compared with the Turbo code, the LDPC code has the following advantages: good bit error performance without a depth interleaver, better frame error rate performance, a greatly reduced error floor, supported parallel decoding, a short decoding delay, and the like.

Therefore, the LDPC code becomes a standard channel encoding scheme for a low-frequency short-range WLAN communication system like IEEE 802.11n/ac/ax, and becomes a mandatory channel encoding scheme in IEEE 802.11ax when a bandwidth is greater than or equal to 40 MHz. Based on this, it may be considered that a new LDPC code is designed for a next-generation WLAN standard or an ultra wideband (ultra wideband, UWB) standard, to further improve reliability and system performance of a next-generation WLAN system or UWB system.

**SUMMARY**

Embodiments of this application disclose an LDPC encoding method, an LDPC decoding method, and a related apparatus to reduce encoding complexity.

According to a first aspect, an embodiment of this application provides an LDPC code encoding method. The method includes: performing low-density parity-check LDPC encoding on a first bit sequence based on a parity check matrix to obtain a first data packet, where the parity check matrix includes a first parity check matrix and a second parity check matrix, both the first parity check matrix and the second parity check matrix conform to a first base matrix, and a code length of the first parity check matrix is different from a code length of the second parity check matrix; and sending the first data packet.

In this embodiment of this application, both the first parity check matrix and the second parity check matrix conform to the first base matrix. The first parity check matrix and the second parity check matrix with different code lengths are obtained by extending the same base matrix, that is, the first base matrix. Compared with implementing one base matrix, implementing a plurality of base matrices requires higher power consumption and increases encoding complexity. In this embodiment of this application, a plurality of parity check matrices are obtained by extending one base matrix, and only one base matrix instead of a plurality of base matrices needs to be implemented. Therefore, hardware power consumption can be reduced, and encoding complexity can be reduced.

In a possible implementation, the performing low-density parity-check LDPC encoding on a first bit sequence based on a parity check matrix to obtain a first data packet includes: when a length of the first bit sequence is within a first interval, performing low-density parity-check LDPC encoding on the first bit sequence based on the first parity check matrix to obtain the first data packet; or when a length of the first bit sequence is within a second interval, performing low-density parity-check LDPC encoding on the first bit sequence based on the second parity check matrix to obtain the first data packet, where the first interval does not overlap the second interval.

In this implementation, a parity check matrix with an appropriate code length is flexibly selected based on the length of the first bit sequence, and LDPC encoding is performed on the first bit sequence. In other words, a most appropriate parity check matrix may be obtained by extending the length of the first bit sequence, and LDPC encoding is performed based on the parity check matrix, so that resource utilization can be improved.

According to a second aspect, an embodiment of this application provides an LDPC code decoding method. The method includes: obtaining a first log-likelihood ratio LLR sequence corresponding to a received first channel receive sequence; and decoding the first LLR sequence based on a parity check matrix, where the parity check matrix includes a first parity check matrix and a second parity check matrix, both the first parity check matrix and the second parity check matrix conform to a first base matrix, and a code length of the first parity check matrix is different from a code length of the second parity check matrix.

In this embodiment of this application, both the first parity check matrix and the second parity check matrix conform to the first base matrix. The first parity check matrix and the second parity check matrix with different code lengths are obtained by extending the same base matrix, that is, the first base matrix. Compared with implementing one base matrix, implementing a plurality of base matrices requires higher power consumption and increases encoding complexity. In this embodiment of this application, a plurality of parity check matrices are obtained by extending one base matrix, and only one base matrix instead of a plurality of base matrices needs to be implemented. Therefore, hardware power consumption can be reduced, and encoding complexity can be reduced.

In a possible implementation of the first aspect and the second aspect, a specific extension factor value of a circulant permutation matrix CPM in a first position in the first parity check matrix is $b$, an extension factor of the CPM in the first position in the first parity check matrix is $Z_1$, a specific extension factor value of a CPM in a first position in the second parity check matrix is $(b \bmod Z)$, and an extension factor of the CPM in the first position in the second parity check matrix is $Z_2$, where $Z$, $Z_1$, and $Z_2$ are all integers greater than 0, $Z_1$ is greater than or equal to $Z$, and $Z_2$ is less than $Z$. The first position may be any position in the first parity check matrix. Optionally, $Z$ is an integer multiple of 27, for example, 27, 54, or 81.

In this implementation, the specific extension factor value of the CPM in the first position in the first parity check matrix is $b$, and the specific extension factor value of the CPM in the first position in the second parity check matrix is $(b \bmod Z)$. The first parity check matrix and the second parity check matrix are obtained by extending the first base matrix. Only the first base matrix needs to be implemented, and a plurality of base matrices need to be implemented. Therefore, hardware power consumption can be reduced, and encoding complexity can be reduced.

In a possible implementation of the first aspect and the second aspect, a specific extension factor value of a CPM in a first position in the first parity check matrix is $b$, an extension factor of the CPM in the first position in the first parity check matrix is $Z_3$, a specific extension factor value of a CPM in a first position in the second parity check matrix is any one of $b$, $(b+Z)$, and $(b+2Z)$, and an extension factor of the CPM in the first position in the second parity check matrix is $Z_4$, where $Z$, $Z_3$, and $Z_4$ are all integers greater than 0, $Z_3$ is less than $Z$, and $Z_4$ is greater than or equal to $Z$. The first position may be any position in the first parity check matrix. Optionally, $Z$ and $Z_4$ are both integer multiples of 27. For example, $Z$ is 27, and $Z_4$ is 54 or 81.

In this implementation, the specific extension factor value of the CPM in the first position in the first parity check matrix is $b$, and the specific extension factor value of the CPM in the first position in the second parity check matrix is any one of $b$, $(b+Z)$, and $(b+2Z)$. The first parity check matrix and the second parity check matrix are obtained by extending the first base matrix. Only the first base matrix needs to be implemented, and there is no need to implement a plurality of base matrices. Therefore, hardware implementation complexity and power consumption can be reduced.

In a possible implementation of the first aspect and the second aspect, the first base matrix corresponds to an original parity check matrix, an extension factor of a CPM in the original parity check matrix is $Z$, a specific extension factor value of a CPM in a first position in the original parity check matrix is $b$, a specific extension factor value of a CPM in a first position in the first parity check matrix is $b$, an extension factor of the CPM in the first position in the first parity check matrix is $Z_1$, a specific extension factor value of a CPM in a first position in the second parity check matrix is $(b \bmod Z)$, and an extension factor of the CPM in the first position in the second parity check matrix is $Z_2$, where $Z$, $Z_1$, and $Z_2$ are all integers greater than 0, $Z_1$ is greater than or equal to $Z$, and $Z_2$ is less than $Z$. Optionally, $Z$ is an integer multiple of 27, for example, 27, 54, or 81. Optionally, the parity check matrix further includes the original parity check matrix.

In this implementation, the specific extension factor value of the circulant permutation matrix CPM in the first position in the first parity check matrix is $b$, and the specific extension factor value of the CPM in the first position in the second parity check matrix is $(b \bmod Z)$; and a required parity check matrix can be quickly obtained through extension.

In a possible implementation of the first aspect and the second aspect, the first base matrix corresponds to an original parity check matrix, an extension factor of a CPM in the original parity check matrix is $Z$, a specific extension factor value of a CPM in a first position in the original parity check matrix is $b$, a specific extension factor value of a CPM in a first position in the first parity check matrix is $(b \bmod Z)$, an extension factor of the CPM in the first position in the first parity check matrix is $Z_3$, a specific extension factor value of a CPM in a first position in the second parity check matrix is any one of $b$, $(b+Z)$, and $(b+2Z)$, and an extension factor of the CPM in the first position in the second parity check matrix is $Z_4$, where $Z$, $Z_3$, and $Z_4$ are all integers greater than 0, $Z_3$ is less than $Z$, and $Z_4$ is greater than or equal to $Z$.

Optionally, $Z$ and $Z_4$ are both integer multiples of 27. For example, $Z$ is 27, and $Z_4$ is 54 or 81.

In this implementation, the specific extension factor value of the CPM in the first position in the first parity check matrix is $(b \bmod Z)$, and the specific extension factor value of the CPM in the first position in the second parity check matrix is any one of $b$, $(b+Z)$, and $(b+2Z)$; and a required parity check matrix can be quickly obtained through extension.

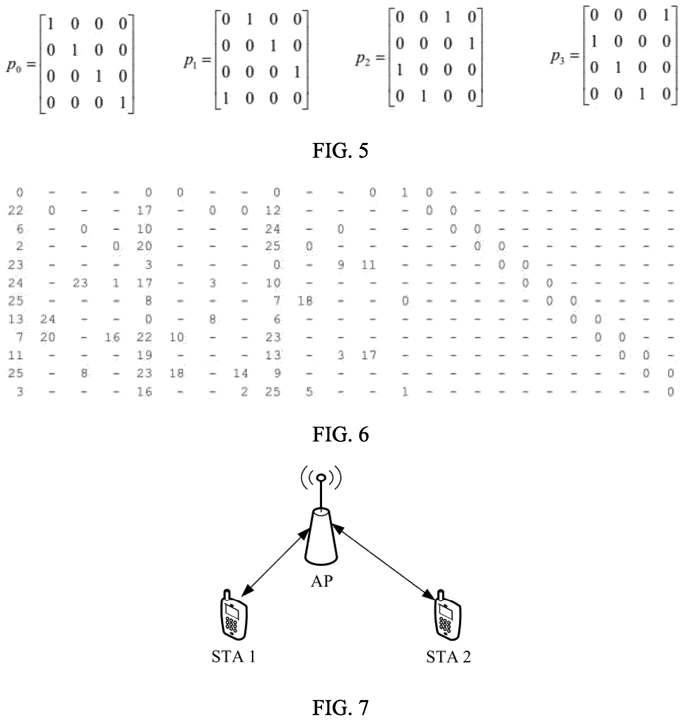

In a possible implementation of the first aspect and the second aspect, the method further includes: obtaining an original parity check matrix by extending the first base matrix, where an extension factor of a CPM in the original parity check matrix is Z; and obtaining the first parity check matrix or the second parity check matrix based on the original parity check matrix, where an extension factor of a CPM in a first position in the first parity check matrix is Z1, an extension factor of a CPM in a first position in the second parity check matrix is Z2, a specific extension factor value of a circulant permutation matrix CPM in a first position in the original parity check matrix is b, a specific extension factor value of the circulant permutation matrix CPM in the first position in the first parity check matrix is b, and a specific extension factor value of the CPM in the first position in the second parity check matrix is (b mod Z), where Z, Z1, and Z2 are all integers greater than 0, Z1 is greater than or equal to Z, and Z2 is less than Z. The original parity check matrix may be a matrix shown in FIG. 6, FIG. 14, or FIG. 15 below.

In this implementation, the first parity check matrix or the second parity check matrix is obtained based on the original parity check matrix; and a required parity check matrix can be quickly obtained.

In a possible implementation of the first aspect and the second aspect, the method further includes: obtaining an original parity check matrix by extending the first base matrix, where an extension factor of a CPM in the original parity check matrix is Z; and obtaining the first parity check matrix or the second parity check matrix based on the original parity check matrix, where an extension factor of a CPM in a first position in the first parity check matrix is Z3, an extension factor of a CPM in a first position in the second parity check matrix is Z4, a specific extension factor value of a circulant permutation matrix CPM in a first position in the original parity check matrix is b, a specific extension factor value of the CPM in the first position in the first parity check matrix is (b mod Z), and a specific extension factor value of the CPM in the first position in the second parity check matrix is any one of b, (b+Z), and (b+2Z), where Z, Z3, and Z4 are all integers greater than 0, Z3 is less than Z, and Z4 is greater than or equal to Z. Optionally, Z and Z4 are both integer multiples of 27. For example, Z is 27, and Z4 is 54 or 81.

In this implementation, the first parity check matrix or the second parity check matrix is obtained based on the original parity check matrix; and a required parity check matrix can be quickly obtained.

According to a third aspect, an embodiment of this application provides a communication apparatus. The communication apparatus has a function of implementing behavior in the method embodiment in the first aspect. The communication apparatus may be a communication device, or may be a component (for example, a processor, a chip, or a chip system) of a communication device, or may be a logical module or software that can implement all or some functions of a communication device. The function of the communication apparatus may be implemented by hardware, or may be implemented by hardware executing corresponding software. The hardware or the software includes one or more modules or units corresponding to the foregoing function. In a possible implementation, the communication apparatus includes an interface module and a processing module. The processing module is configured to perform low-density parity-check LDPC encoding on a first bit sequence based on a parity check matrix to obtain a first data packet, where the parity check matrix includes a first parity check matrix and a second parity check matrix, both the first parity check matrix and the second parity check matrix conform to a first base matrix, and a code length of the first parity check matrix is different from a code length of the second parity check matrix. The interface module is configured to send the first data packet.

For possible implementations of the communication apparatus in the third aspect, refer to the possible implementations of the first aspect.

For technical effects achieved by the possible implementations of the third aspect, refer to descriptions of technical effects of the first aspect or the possible implementations of the first aspect.

According to a fourth aspect, an embodiment of this application provides a communication apparatus. The communication apparatus has a function of implementing behavior in the method embodiment in the second aspect. The communication apparatus may be a communication device, or may be a component (for example, a processor, a chip, or a chip system) of a communication device, or may be a logical module or software that can implement all or some functions of a communication device. The function of the communication apparatus may be implemented by hardware, or may be implemented by hardware executing corresponding software. The hardware or the software includes one or more modules or units corresponding to the foregoing function. In a possible implementation, the communication apparatus includes an interface module and a processing module. The interface module is configured to receive a first channel receive sequence. The processing module is configured to obtain a first log-likelihood ratio LLR sequence corresponding to the first channel receive sequence; and decode the first LLR sequence based on a parity check matrix, where the parity check matrix includes a first parity check matrix and a second parity check matrix, both the first parity check matrix and the second parity check matrix conform to a first base matrix, and a code length of the first parity check matrix is different from a code length of the second parity check matrix.

For possible implementations of the communication apparatus in the fourth aspect, refer to the possible implementations of the second aspect.

For technical effects achieved by the possible implementations of the fourth aspect, refer to descriptions of technical effects of the second aspect or the possible implementations of the second aspect.

According to a fifth aspect, an embodiment of this application provides another communication apparatus. The communication apparatus includes a processor, the processor is coupled to a memory, the memory is configured to store a program or instructions, and when the program or the instructions are executed by the processor, the communication apparatus is enabled to perform the method according to any one of the first aspect or the possible implementations of the first aspect, or when the program or the instructions are executed by the processor, the communication apparatus is enabled to perform the method according to any one of the second aspect or the possible implementations of the second aspect.

In this embodiment of this application, in a process of performing the method, a process of sending information (or a signal) in the method may be understood as a process of outputting information based on instructions of the processor. When the information is output, the processor outputs the information to a transceiver, so that the transceiver transmits the information. After the information is output by the processor, the information may further require other processing, and then reaches the transceiver. Similarly, when the processor receives input information, the transceiver receives the information, and inputs the information into the processor. Further, after the transceiver receives the information, other processing may need to be performed on the information before the information is input into the processor.

An operation such as sending and/or receiving involved in the processor may be generally understood as an instruction output based on the processor if there is no special description, or if the operation does not conflict with an actual function or internal logic of the operation in a related description.

In an implementation process, the processor may be a processor specially configured to perform these methods, or may be a processor that executes computer instructions in the memory to perform these methods, for example, a general-purpose processor. For example, the processor may be further configured to execute the program stored in the memory. When the program is executed, the communication apparatus is enabled to perform the method according to any one of the first aspect or the possible implementations of the first aspect.

In a possible implementation, the memory is located outside the communication apparatus. In a possible implementation, the memory is located in the communication apparatus.

In a possible implementation, the processor and the memory may be further integrated into one component, that is, the processor and the memory may be further integrated together.

In a possible implementation, the communication apparatus further includes the transceiver. The transceiver is configured to receive a signal, send a signal, or the like.

According to a sixth aspect, this application provides another communication apparatus. The communication apparatus includes a processing circuit and an interface circuit. The interface circuit is configured to obtain data or output data. The processing circuit is configured to perform a corresponding method according to any one of the first aspect or the possible implementations of the first aspect, or the processing circuit is configured to perform a corresponding method according to any one of the second aspect or the possible implementations of the second aspect.

According to a seventh aspect, this application provides a computer-readable storage medium. The computer-readable storage medium stores a computer program, the computer program includes program instructions, and when the program instructions are executed, a computer is enabled to perform the method according to any one of the first aspect or the possible implementations of the first aspect, or when the program instructions are executed, a computer is enabled to perform the method according to any one of the second aspect or the possible implementations of the second aspect.

According to an eighth aspect, this application provides a computer program product. The computer program product includes a computer program, the computer program includes program instructions, and when the program instructions are executed, a computer is enabled to perform the method according to any one of the first aspect or the possible implementations of the first aspect, or when the program instructions are executed, a computer is enabled to perform the method according to any one of the second aspect or the possible implementations of the second aspect.

According to a ninth aspect, this application provides a communication system, including the communication apparatus according to any one of the third aspect or the possible implementations of the third aspect and the communication apparatus according to any one of the fourth aspect or the possible implementations of the fourth aspect.

## BRIEF DESCRIPTION OF DRAWINGS

To describe the technical solutions in embodiments of this application or in the background more clearly, the following briefly describes the accompanying drawings for describing embodiments of this application or the background.

FIG. 1 is an example of a parity check matrix H of an LDPC code according to this application;
FIG. 2 is a Tanner graph of a parity check matrix H of an LDPC code according to an embodiment of this application;
FIG. 3 is an example of an LDPC code encoding process according to this application;
FIG. 4 is a diagram of a shortening operation part in an LDPC encoding procedure according to an embodiment of this application;
FIG. 5 is an example of four CPMs according to an embodiment of this application;
FIG. 6 is an example of a parity check matrix obtained by extending a base matrix with a size of $(12 \times 24)$ according to an embodiment of this application;

FIG. 7 is an example of a wireless communication system to which a technical solution provided in this application is applicable;

FIG. 8 is an interaction flowchart of an LDPC code encoding method according to this application;

FIG. 9 is an interaction flowchart of another LDPC code encoding method according to this application;

FIG. 10 is an interaction flowchart of another LDPC code encoding method according to an embodiment of this application;

FIG. 11 is an example of a matrix representing a first base matrix and specific extension factor value matrices of four parity check matrices obtained by extending the first base matrix according to an embodiment of this application;

FIG. 12 is an example of a first parity check matrix according to an embodiment of this application;

FIG. 13 is an example of another matrix representing a first base matrix and specific extension factor value matrices of four parity check matrices obtained by extending the first base matrix according to an embodiment of this application;

FIG. 14 is an example of a parity check matrix obtained by extending base matrix 2 according to this application;

FIG. 15 is an example of a parity check matrix obtained by extending base matrix 2 according to this application;

FIG. 16A is a diagram of comparison of FER simulation performance of an LDPC code in 25 iterations of layered decoding according to an embodiment of this application;

FIG. 16B is a diagram of comparison of FER simulation performance of an LDPC code in 15 iterations of layered decoding according to an embodiment of this application;

FIG. 16C is a diagram of comparison of FER simulation performance of an LDPC code in five iterations of layered decoding according to an embodiment of this application;

FIG. 17A is a diagram of performance of parity check matrix 41, parity check matrix 42, parity check matrix 43, and parity check matrix 44 in 10 iterations of decoding according to an embodiment of this application;

FIG. 17B is a diagram of performance of parity check matrix 41, parity check matrix 42, parity check matrix 43, and parity check matrix 44 in 15 iterations of decoding according to an embodiment of this application;

FIG. 17C is a diagram of performance of parity check matrix 41, parity check matrix 42, parity check matrix 43, and parity check matrix 44 in 25 iterations of decoding according to an embodiment of this application;

FIG. 18A is a diagram of performance of parity check matrix 51, parity check matrix 52, parity check matrix 53, and parity check matrix 54 in 10 iterations of decoding according to an embodiment of this application;

FIG. 18B is a diagram of performance of parity check matrix 51, parity check matrix 52, parity check matrix 53, and parity check matrix 54 in 15 iterations of decoding according to an embodiment of this application;

FIG. 18C is a diagram of performance of parity check matrix 51, parity check matrix 52, parity check matrix 53, and parity check matrix 54 in 25 iterations of decoding according to an embodiment of this application;

FIG. 19 is a diagram of a structure of a communication apparatus 1900 according to an embodiment of this application;

FIG. 20 is a diagram of a structure of another communication apparatus 200 according to an embodiment of this application; and

FIG. 21 is a diagram of a structure of another communication apparatus 210 according to an embodiment of this application.

## DESCRIPTION OF EMBODIMENTS

Terms "first", "second", and the like in the specification, claims, and accompanying drawings of this application are merely used to distinguish between different objects, and are not used to describe a specific order. In addition, terms such as "include" and "have" and any other variants thereof are intended to cover a non-exclusive inclusion. For example, processes, methods, systems, products, or devices that include a series of steps or units are not limited to listed steps or units, but optionally further include steps or units that are not listed, or optionally further include other steps or units inherent to these processes, methods, products, or devices.

In this application, the term "example", "for example", or the like is used to represent an example, an illustration, or a description. Any embodiment or design scheme described with "example", "in an example", or "for example" in this application should not be construed as being more preferred or advantageous than another embodiment or design scheme. Exactly, use of the term "example", "in an example", "for example", or the like is intended to present a related concept in a specific manner.

In this specification, reference to "an embodiment" means that specific features, structures or characteristics described with reference to the embodiment may be incorporated in at least one embodiment of this application. The phrase shown in various positions in the specification may not necessarily refer to a same embodiment, and is not an independent or alternative embodiment exclusive from another embodiment. It may be understood explicitly and implicitly by a person skilled in the art that the embodiments described in this specification may be combined with other embodiments.

Terms used in the following embodiments of this application are merely intended to describe specific embodiments, but are not intended to limit this application. As used in the specification and the appended claims of this application, terms "one", "a", "an", "the", and "this" expressed in singular forms are also intended to include plural forms, unless otherwise specified in the context clearly. It should also be understood that the term "and/or" used in this application indicates and includes any or all possible combinations of one or more listed items. For example, "A and/or B" may represent three cases: Only A exists, only B exists, and both A and B exist, where A and B may be singular or plural. The term "a plurality of" used in this application means two or more than two.

It may be understood that in embodiments of this application, "B corresponding to A" indicates that there is a correspondence between A and B, and B may be determined based on A. However, it should also be understood that determining (or generating) B based on (or based on) A does not mean that B is determined (or generated) based only on (or based on) A, and B may alternatively be determined (or generated) based on (or based on) A and/or other information.

To facilitate understanding of the solutions in this application, related concepts of an LDPC code in this application are first described.

The LDPC code is short for low-density parity-check code. Literally, the LDPC code is a parity check code featuring a low density. The low density herein means that a parity check matrix of the LDPC code has a low density. Therefore, to understand what the LDPC code is, it is necessary to first understand three concepts: the parity check code, the parity check matrix, and the low density.

1. Parity check code

The parity check code is an encoding method in which a redundant bit is added to make a quantity of 1s in a codeword always odd or even. The parity check code is usually used for digital encoding in a binary field of 0 and 1. One or more bits (parity bits) are added to the end of a codeword. Whether an error occurs in the codeword before and after transmission is determined by determining whether a quantity of 1s in the codeword is an odd number or an even number. For example, if a codeword 100 uses parity check, a parity bit may be 1. In this case, a sum (exclusive OR) value s of the entire codeword is 0, that is, 1001. If the codeword changes to 1101 after transmission, an information bit (which may be referred to as a bit) is incorrect, s is 1, and it can be determined that a transmission error occurs. It should be understood that if an even quantity of information bits is incorrect, an algorithm is invalid. Therefore, further, a plurality of parity bits may be set. For example, a four-bit codeword 1101 may be grouped, and a first bit of parity bits is used to check a first bit and a second bit of information bits (that is, the first two bits 11 of the information bits). For example, if a sum of the first two bits of the information bits is 0, the first bit of the parity bits should be set to 0. Similarly, a second bit of the parity bits may be used to check last two information bits of the codeword 1101. In this case, the second bit of the parity bits is set to 1. Therefore, an encoded codeword is 110101. This is actually a check idea of the LDPC code, that is, a meaning of "PC". It can be learned that the LDPC code is a block code and actually uses parity check. If a low density feature is added, the LDPC code can be obtained.

2. Low density feature of the LDPC code

The low density feature of the LDPC code means that a quantity of 1s in a parity check matrix of the LDPC code is small. The LDPC code is a linear block code, and the parity check matrix of the LDPC code is a sparse matrix. A quantity of zero elements in the parity check matrix of the LDPC code is far greater than a quantity of non-zero elements. In other words, a row weight (that is, a quantity of 1s in each row) and a column weight (that is, a quantity of 1s in each column) of the parity check matrix are far less than a code length of the LDPC code.

3. Parity check matrix and generator matrix of the LDPC code

The codeword 1101 is used as an example. A check relationship between information bits and parity bits of a codeword may be expressed in a form of a matrix. The information bits are denoted as c1, c2, c3, and c4, and the parity bits are denoted as p1 and p2. c = [c1, c2, c3, c4], x = [c1, c2, c3, c4, p1, p2]. Herein, c and x are codewords before and after encoding respectively. In the example of the codeword 1101, a check relationship between information bits and parity bits of the codeword 1101 may be represented as the following linear relationships: c1 + c2 + p1 = 0, and c3 + c4 + p2 = 0. The linear relationships may be expressed as the following formula:

$$x \cdot H^T = s = 0 \quad (1),$$

where

H is $\begin{bmatrix} 1 & 1 & 0 & 0 & 1 & 0 \\ 0 & 0 & 1 & 1 & 0 & 1 \end{bmatrix}$, and s = (0, 0). Herein, H is a parity check matrix, s is a checksum, and $H^T$ represents a transposition of H. An idea of the formula (1) is that after an original codeword (an unencoded codeword) c is encoded by using a generator matrix G (G is determined by H), an obtained transmit codeword x needs to satisfy $x \cdot H^T = 0$. To easily determine whether a result is 0, a concept of the checksum s is introduced. As long as s is all 0s, transmission is normal. In this application, "·" represents a matrix multiplication operation, and "A·B" represents a product of matrix multiplication of matrix A and matrix B.

The transmit codeword x obtained by encoding c by using the generator matrix G may satisfy the following formula:

$$x = c \cdot G \qquad (2)$$

Herein, c represents an unencoded codeword (or a bit sequence), and G represents the generator matrix. G and $H^T$ are orthogonal to each other, that is, $G \cdot H^T = 0$. The generator matrix may be obtained by transforming the parity check matrix. In other words, after the parity check matrix is known, the generator matrix corresponding to the parity check matrix may be obtained. c may be referred to as an information codeword, and x may be referred to as a transmit codeword. The formula (2) indicates that the transmit codeword is obtained by multiplying the information codeword by the generator matrix.

4. Tanner graph

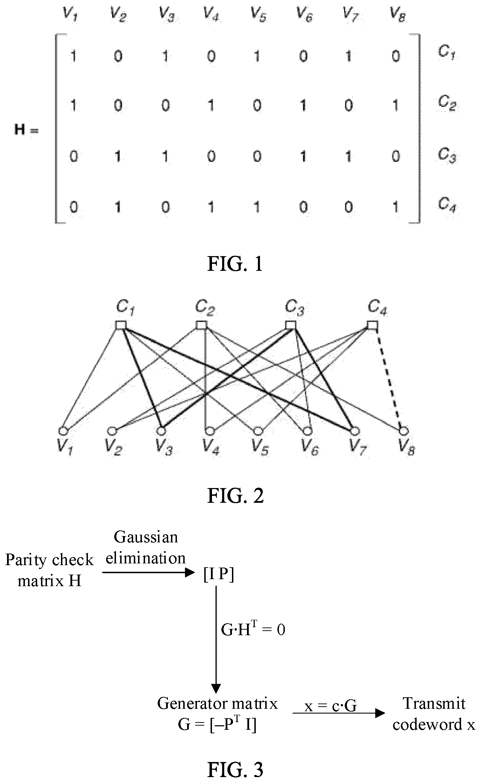

In 1981, Tanner represented a codeword of an LDPC code in a graph. Currently, this graph is referred to as the Tanner graph, and the Tanner graph is in a one-to-one correspondence with a parity check matrix. The Tanner graph includes two types of vertices. One type of vertex is a variable node, representing a codeword bit. The other type of vertex is a check node, representing a check constraint relationship. Each check node represents a check constraint relationship, which is described below with reference to FIG. 1 and FIG. 2.

Refer to FIG. 1. FIG. 1 is an example of a parity check matrix H of an LDPC code according to this application. In FIG. 1, $\{V_i\}$ represents a variable node set, and $\{C_i\}$ represents a check node set. Each row of the parity check matrix H corresponds to one check equation, and each column of the parity check matrix H corresponds to one codeword bit. In FIG. 1, there are eight variable nodes and four check nodes. If a codeword bit is included in a corresponding check equation, a connection line is used to connect an involved variable node and an involved check node, to obtain a Tanner graph.

Refer to FIG. 2. FIG. 2 is a Tanner graph of a parity check matrix H of an LDPC code according to an embodiment of this application. As shown in FIG. 2, the Tanner graph represents the parity check matrix of the LDPC code. For example, for the parity check matrix H with a size of m rows and n columns, the Tanner graph includes two types of nodes: n variable nodes (which may also be referred to as information nodes or bit nodes) and m check nodes, where both m and n are integers greater than 0. The n variable nodes correspond to n columns of the parity check matrix H, and the m check nodes correspond to m rows of the parity check matrix H. A cycle in the Tanner graph consists of connected vertices. The cycle uses one of the vertices as both a start point and an end point, and passes through each node only once. A length of the cycle is defined as a quantity of connection lines included in the cycle. A perimeter of the graph may also be referred to as a size of the graph, and is defined as a minimum cycle length in the graph. In FIG. 2, the perimeter is 6, as shown by a bold connection line in FIG. 2.

5. LDPC code encoding

It can be learned from the foregoing description that the transmit codeword is obtained by multiplying the information codeword by the generator matrix, and the generator matrix may be obtained by transforming the parity check matrix. Therefore, an entire LDPC code encoding process is actually a process of constructing the parity check matrix. Refer to FIG. 3. FIG. 3 is an example of an LDPC code encoding process according to this application. As shown in FIG. 3, the parity check matrix H may be transformed into H = [I P] through Gaussian elimination; a generator matrix $G = [-P^T \ I]$ is obtained based on $G \cdot H^T = 0$; and the information codeword c is encoded by using the generator matrix G, to obtain the transmit codeword x, that is, $x = c \cdot G$. I represents an information bit part, P represents a parity bit part, and x is the transmit codeword.

6. LDPC code decoding

In an LDPC code decoding process, message iterations are continuously performed between variable nodes and check nodes according to a check rule between parity bits (or referred to as parity elements) and information bits (or referred to as information elements) until a codeword satisfying $x \cdot H^T =$ is found, and an output x is a decoded codeword. LDPC code decoding algorithms include the following three main categories: hard-decision decoding, soft-decision decoding, and hybrid decoding.

7. LDPC encoding in a WLAN scenario

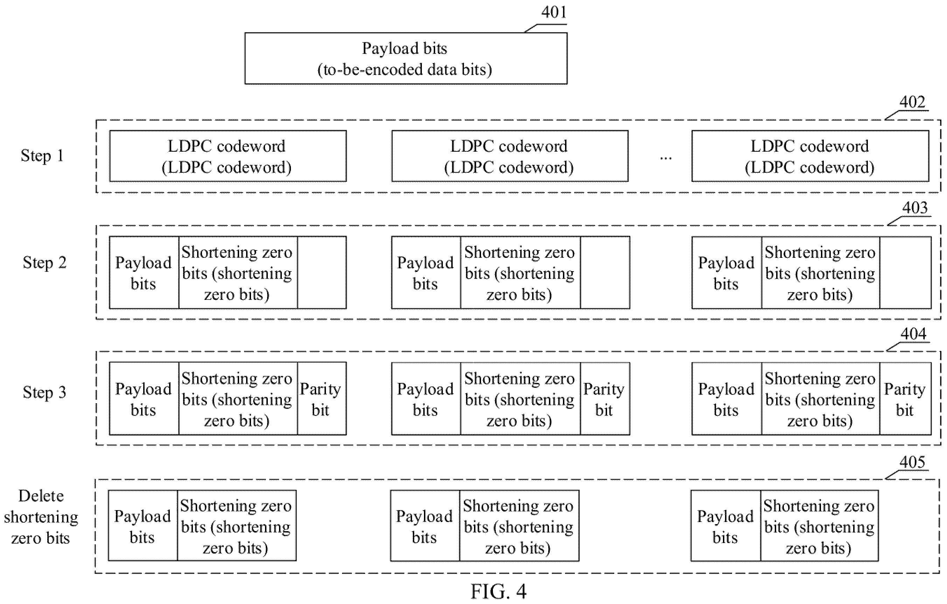

Some WLAN standards (for example, IEEE 802.11n/ac) use an orthogonal frequency division multiplexing (orthogonal frequency division multiplexing, OFDM) technology. An LDPC encoding module needs to encode data bits (which may be referred to as information bits) and place the encoded data bits into an integer quantity of OFDM symbols, and these encoded bits also need to be exactly capable of being placed into an integer quantity of LDPC codewords. To perform the foregoing steps, a transmit end first calculates a minimum quantity $N_{SYM}$ of OFDM symbols required for current transmission, and then calculates, based on $N_{SYM}$ and a current modulation and coding scheme, a total quantity of encoded bits that can be stored in all the OFDM symbols: $N_{TCB} = N_{CBPS} * N_{SYM}$, where $N_{CBPS}$ is a quantity of bits that can be stored in each OFDM symbol. Subsequently, the transmit end calculates, based on the obtained result, a length of an LDPC code used in the current transmission and a quantity of required codewords. For most combinations of bit lengths and modulation and coding schemes of to-be-encoded data, because data bits for filling a data bit part in an LDPC codeword are insufficient, a shortening operation needs to be performed before a parity bit is generated. The data bit part in the LDPC codeword includes only an information bit (or a data bit), and does not include a parity bit (or a parity bit).
In this application, the shortening operation means that before the parity bit is generated through LDPC encoding, a specific quantity of 0s are filled in a data bit part of codeword information, and these 0s are deleted after the parity bit is generated through encoding. FIG. 4 is a diagram of a shortening operation part in an LDPC encoding procedure according to an embodiment of this application. As shown in FIG. 4, 401 represents to-be-encoded data bits (payload bits); step (step) 1 is to calculate a length of an LDPC codeword and a quantity of codewords required for sending the to-be-encoded data bits, and 402 shows the length of the LDPC codeword and the quantity of codewords; step 2 is to perform a shortening operation on the to-be-encoded data bits, and 403 shows codewords including the data bits and shortening zero bits (shortening zero bits); step 3 is to generate parity bits (parity bits) by using the data bits and the shortening zero bits, and 404 shows codewords including the data bits, the shortening zero bits, and the parity bits; and these shortening zero bits are then deleted (discard shortening bits), and 405 shows codewords including only the data bits and the parity bits.

8. Obtaining a parity check matrix by extending a base matrix

Base matrices of LDPC codes may be extended to parity check matrices of the LDPC codes with various code lengths as required. A base matrix of an LDPC code includes only two types of elements: 0 and 1. In this application, 0 in the base matrix may be replaced with a blank, "-", "-1", or another number or symbol. This is not limited in this application. In this application, when the parity check matrix is obtained by extending the base matrix, 1 in the base matrix may be extended to a non-all-zero square matrix (which may also be referred to as a non-all-zero square matrix), and a zero element in the base matrix may be extended to an all-zero square matrix (which may also be referred to as an all-zero square matrix). In this application, the all-zero square matrix is a square matrix in which all included elements are 0, for example, a square matrix with a size of $(27 \times 27)$. In this application, the non-all-zero square matrix is a square matrix including at least one non-zero element, for example, a circulant permutation matrix (circulant permutation matrix, CPM). The CPM is a cyclic shift of an identity matrix. In other words, the cyclic shift of the identity matrix is referred to as the CPM. Meanings of all subsequent CPMs are the same as above, and are not described again subsequently. In this application, any CPM may be represented by a value and an extension factor together. In other words, any CPM corresponds to one value and one extension factor. That sizes of two CPMs are different means that the two CPMs correspond to different extension factors. In this application, a value corresponding to the CPM may be referred to as a specific extension factor value, an extension factor value, a cyclic shift factor, or the like. A value corresponding to the CPM may be referred to as a cyclic shift coefficient. An extension factor corresponding to the CPM represents a size of the CPM, that is, CPMs with different sizes have different extension factors. For example, an extension factor of a CPM with a size of $(27 \times 27)$ is 27. In other words, if the extension factor of the CPM is 27, it indicates that the size of the CPM is $(27 \times 27)$. For another example, an extension factor of a CPM with a size of $(54 \times 54)$ is 54. Meanings of extension factors of all subsequent CPMs are the same as above, and are not described again subsequently. It should be noted that extension factors of CPMs in the parity check matrix are the same. For example, a size of a base matrix is $(12 \times 24)$, and the base matrix is extended by using an extension factor $Z = 27$, to obtain a parity check matrix, where an extension factor of each CPM in the parity check matrix is Z. In this application, a value (integer) corresponding to the CPM represents a quantity of bits that are cyclically shifted to the right in the identity matrix. FIG. 5 is an example of four CPMs $(4 \times 4)$ according to this application. As shown in FIG. 5, $P_0$ represents an identity matrix $(4 \times 4)$, $P_0$ may be considered as a CPM with an extension factor of 4 and corresponding to a value of 0, $P_1$ is a CPM with an extension factor of 4 and corresponding to a value of 1, $P_2$ is a CPM with an extension factor of 4 and corresponding to a value of 2, and $P_3$ is a CPM with an extension factor of 4 and corresponding to a value of 3. FIG. 5 is an example of four CPMs according to an embodiment of this application. It should be understood that any CPM may be obtained by performing a right cyclic shift on a corresponding identity matrix. Details are not described herein again. It may be understood that 1 in the base matrix may be extended to a CPM of any size, and 0 in the base matrix may be extended to an all-zero square matrix of any size. A meaning or a function of 1 or 0 in a subsequent base matrix is consistent with that in the foregoing description, and is not described again.

A manner of obtaining the parity check matrix by extending the base matrix may be as follows: 1 in the base matrix is replaced with a CPM, and 0 in the base matrix is replaced with an all-zero square matrix with a corresponding size. For example, each element in the base matrix is 0 or 1. When the parity check matrix is obtained by extending the base matrix, each 0 in the base matrix is extended to an all-zero matrix ($Z\times Z$), and each 1 in the base matrix is extended to a CPM ($Z\times Z$), where Z is an extension factor corresponding to the CPM, and values corresponding to different CPMs are the same or different. Therefore, a series of parity check matrices of LDPC codes may be obtained based on the base matrix. Sizes of these parity check matrices and extension factors of the CPMs may be different, but the parity check matrices and the CPMs correspond or conform to the same base matrix.

The following is an example of a parity check matrix obtained by extending a base matrix. An example of a base matrix with a size of ($12\times24$) is as follows:

```
            1 0 0 0 1 1 0 0 1 0 0 1 1 1 0 0 0
  0 0 0 0 0 0 0 0
            1 1 0 0 1 0 1 1 1 0 0 0 0 1 1 0 0
  0 0 0 0 0 0 0 0
            1 0 1 0 1 0 0 0 1 0 1 0 0 0 1 1 0
  0 0 0 0 0 0 0 0
            1 0 0 1 1 0 0 0 1 1 0 0 0 0 0 1 1
  0 0 0 0 0 0 0 0
            1 0 0 0 1 0 0 0 1 0 1 1 0 0 0 0 1
  1 0 0 0 0 0 0 0
            1 0 1 1 1 0 1 0 1 0 0 0 0 0 0 0 0
  1 1 0 0 0 0 0 0
            1 0 0 0 1 0 0 0 1 1 0 0 1 0 0 0 0
  0 1 1 0 0 0 0 0
            1 1 0 0 1 0 1 0 1 0 0 0 0 0 0 0 0
  0 0 1 1 0 0 0 0
            1 1 0 1 1 1 0 0 1 0 0 0 0 0 0 0 0
  0 0 0 1 1 0 0 0
              0 0 0 1 0 0 0 1 0 1 1 0 0 1 0 0 0
  0 0 0 1 1 0 0 0
            1 0 1 0 1 1 0 1 1 0 0 0 0 0 0 1 0
  0 0 0 0 0 1 1 0
            1 0 0 0 1 0 0 1 1 1 0 0 1 0 0 0 0
  0 0 0 0 0 0 1
```

Refer to FIG. 6. FIG. 6 is an example of a parity check matrix obtained by extending a base matrix (base matrix 1 below) with a size of ($12\times24$) according to an embodiment of this application. As shown in FIG. 6, "-" in the parity check matrix represents an all-zero matrix with a size of ($K\times K$), 0 in the parity check matrix represents an identity matrix (or referred to as an identity matrix) with a size of ($K\times K$), an element greater than 0 in the parity check matrix represents a CPM corresponding to a value of the element and with a size of ($K\times K$), and K represents an extension factor. In other words, the identity matrix with the size of ($K\times K$) is a cyclic shift of the value of the element greater than 0 in the parity check matrix. In this application, "-" in the parity check matrix (representing an all-zero matrix) may be replaced with a blank, "-1", or another number or symbol. This is not limited in this application. A meaning or a function of "-" or 0 in a subsequent parity check matrix is the same as that in the foregoing description, and is not described again.

A process of extending the base matrix to the parity check matrix is described above by using an example. It should be understood that any base matrix may be extended in a same manner to obtain a parity check matrix with a required code length. In this application, if a parity check matrix is obtained by extending a base matrix, it may be understood that the parity check matrix conforms to (or satisfies) the base matrix, or the parity check matrix corresponds to the base matrix.

To improve transmission reliability of a wireless transmission system, an LDPC code is widely used in a WLAN standard. Compared with the IEEE 802.15.4z standard, a new IEEE 802.15ab standard may introduce a new LDPC encoding technology, to greatly improve data transmission reliability of the system. Therefore, it may be considered that a new LDPC code is designed for a next-generation WLAN standard or UWB standard, to further improve reliability and system performance of a next-generation WLAN system or UWB system.

To improve reliability and system performance of the next-generation WLAN system or UWB system, this application provides two designs for the next-generation WLAN system or UWB system in which parity check matrices with different code lengths are obtained by extending a single base matrix. A solution provided in this application in which parity check matrices with different code lengths are obtained by extending a single base matrix is applicable to a transmission scenario in which a medium packet, a short packet, and a long packet all exist, and encoding complexity is relatively low. In a first solution, parity check matrices with different code lengths are obtained by extending a base matrix corresponding to an existing parity check matrix. For example, parity check matrices with different code lengths are obtained by extending a base matrix corresponding to a parity check matrix whose code rate is 1/2 in an LDPC code in the IEEE 802.11n standard. In a second solution, a plurality of factors such as performance, a decoding convergence speed, and decoding complexity of an LDPC code are comprehensively considered, and several groups of base matrices and corresponding parity check matrices of LDPC codes with low complexity and fast decoding convergence are designed.

The technical solutions of this application are mainly applicable to a wireless communication system. The wireless communication system may comply with a wireless communication standard of the Third Generation Partnership Project (Third Generation Partnership Project, 3GPP), or may comply with another wireless communication standard, for example, a wireless communication standard in the 802 series (for example, 802.11, 802.15, or 802.20) of the Institute of Electrical and Electronics Engineers (Institute of Electrical and Electronics Engineers, IEEE). The technical solutions of this application are further applicable to a wireless local area network system, for example, an Internet of Things (Internet of Things, IoT) network, a UWB system, or a vehicle-to-everything (Vehicle to X, V2X) network. Certainly, embodiments of this application are further applicable to other possible communication systems, for example, a long term evolution (long term evolution, LTE) system, an LTE frequency division duplex (frequency division duplex, FDD) system, an LTE time division duplex (time division duplex, TDD) system, a universal mobile telecommunications system (universal mobile telecommunications system, UMTS), a worldwide interoperability for microwave access (worldwide interoperability for microwave access, WiMAX) communication system, a 5th generation (5th generation, 5G) communication system, and a future 6th generation (6th generation, 6G) communication system.

Embodiments of this application are mainly described by using a network in which a WLAN system or a UWB system is deployed, and in particular, a network to which the IEEE 802.11 standard is applied, as an example. A person skilled in the art easily understands that aspects of this application may be extended to other networks using various standards or protocols, for example, Bluetooth (Bluetooth), high-performance radio LAN (high performance radio LAN, HIPERLAN) (a wireless standard similar to the IEEE 802.11 standard, mainly used in Europe), and a wide area network (WAN), a personal area network (personal area network, PAN), or another network that is known currently or developed in the future. Therefore, regardless of used coverage and a used wireless access protocol, various aspects provided in this application are applicable to any appropriate wireless network.

The foregoing communication systems to which this application is applicable are only examples for description, and the communication systems to which this application is applicable are not limited thereto. This is uniformly described herein, and details are not described below again.

Refer to FIG. 7. FIG. 7 is an example of a wireless communication system to which a technical solution provided in this application is applicable. The communication system includes an access point (access point, AP) and one or more STAs (only a STA 1 and a STA 2 are shown). Both the access point and the STA support a WLAN protocol. The WLAN protocol may include IEEE 802.11be (or referred to as Wi-Fi 7, the EHT protocol), and may further include protocols such as IEEE 802.15ab, IEEE 802.11ax, and IEEE 802.11ac. Certainly, with continuous evolution and development of communication technologies, the WLAN protocol may further include a next-generation protocol of IEEE 802.11be, or the like. A WLAN is used as an example. An apparatus for implementing a method in this application may be an access point or a STA in the WLAN, or a chip or a processing system installed in an access point or a STA.

The access point is an apparatus having a wireless communication function. The access point supports communication by using the WLAN protocol, and has a function of communicating with another device (for example, a station or another access point) in the WLAN network. Certainly, the access point may further have a function of communicating with another device. The WLAN system includes one or more access point (access point, AP) stations and one or more non access point stations (none access point station, non-AP STA). For ease of description, an access point station is referred to as an access point (AP), and a non access point station is referred to as a station (STA) in this specification.

The access point may be an entire device, or may be a chip, a processing system, or the like installed in an entire device. The device in which the chip or the processing system is installed may implement a method and a function in embodiments of this application under control of the chip or the processing system (that is, the AP). The AP in embodiments of this application is an apparatus that provides a service for a station (Station, STA), and may support 802.11 series protocols, for example, 802.15ab, 802.11ac, 802.11n, 802.11g, 802.11b, 802.11a, 802.11be, Wi-Fi 8, or a next generation thereof. For example, the AP may be a communication entity such as a communication server, a router, a switch, or a bridge. The AP may include a macro base station, a micro base station (also referred to as a small cell), a pico base station, a femto base station, a relay station, an access point, a gNB, a transmission and reception point (transmission reception point, TRP), an evolved NodeB (evolved NodeB, eNB), a radio network controller (radio network controller, RNC), a home base station (for example, a home evolved NodeB or a home NodeB, HNB), a baseband unit (baseband unit, BBU), a Wi-Fi access point (access point, AP), integrated access and backhaul (integrated access and backhaul, IAB), or the like. Certainly, the AP may alternatively be a chip and a processing system in devices in various forms, to implement the method and the function in embodiments of this application.

The station is an apparatus having a wireless communication function. The station supports communication by using the WLAN protocol, and has a capability of communicating with another station or an access point in the WLAN network. For example, the STA is any communication apparatus that allows a user to communicate with the AP and further communicate with the WLAN. The communication apparatus may be an entire device, or may be a chip, a processing system, or the like installed in an entire device. The device in which the chip or the processing system is installed may implement a method and a function in embodiments of this application under control of the chip or the processing system (that is, the station). The STA may include a mobile phone (mobile phone), a mobile station (mobile station, MS), a tablet computer (pad), a computer with a wireless transceiver function (for example, a notebook computer), a virtual reality (virtual reality, VR) device, an augmented reality (augmented reality, AR) device, a wireless terminal in industrial control (industrial control), a wireless terminal in self driving (self driving), a wireless terminal in telemedicine (remote medical), a wireless terminal in a smart grid (smart grid), a wireless terminal in transportation safety (transportation safety), a wireless terminal in a smart city (smart city), or a wireless terminal, a subscriber unit (subscriber unit), a cellular phone (cellular phone), a wireless data card, a personal digital assistant (personal digital assistant, PDA) computer, a tablet computer, a laptop computer (laptop computer), a machine type communication (machine type communication, MTC) terminal, or the like in a smart home (smart home). The station may include various handheld devices having a wireless communication function, vehicle-mounted devices, wearable devices, computing devices, or other processing devices connected to a wireless modem. Optionally, the station may be a handheld device (handset) having a wireless communication function, a vehicle-mounted device, a wearable device, a terminal in the Internet of Things or a vehicle-to-everything network, a terminal in any form in 5G and an evolved communication system after 5G, or the like. This is not limited in this application. The station may support 802.11 series protocols, for example, a plurality of WLAN standards such as 802.15ab, 802.11ac, 802.11n, 802.11g, 802.11b, 802.11a, 802.11be, Wi-Fi 8, or a next generation thereof.

The following provides an LDPC code encoding method with reference to the accompanying drawings in this application.

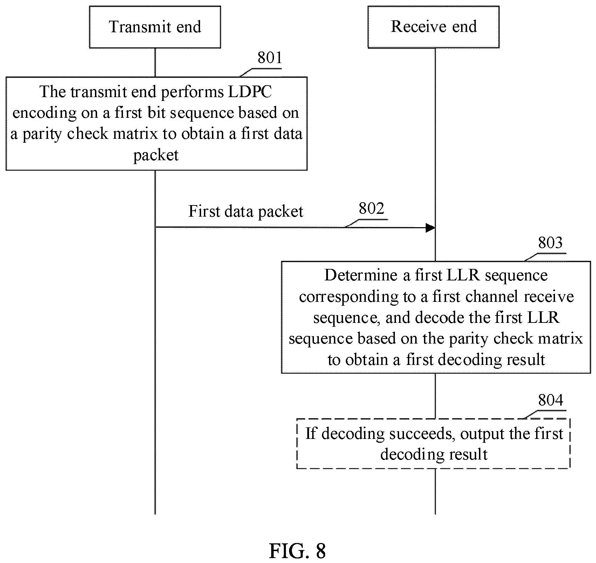

FIG. 8 is an interaction flowchart of an LDPC code encoding method according to this application. As shown in FIG. 8, the method includes the following steps.

801: A transmit end performs LDPC encoding on a first bit sequence based on a parity check matrix to obtain a first data packet.

The transmit end may be a station, or may be an access point. The transmit end in this embodiment of this application may be considered as an encoding device. The parity check matrix includes two or more parity check matrices that conform to a first base matrix. Code lengths of any two of the two or more parity check matrices included in the parity check matrix and conforming to the first base matrix are different. In the following description, it is assumed that the parity check matrix includes a first parity check matrix and a second parity check matrix. Both the first parity check matrix and the second parity check matrix conform to the first base matrix. A code length of the first parity check matrix is different from a code length of the second parity check matrix.

A possible implementation of step 801 is: obtaining first information based on the first bit sequence and a generator matrix corresponding to the first parity check matrix; and obtaining the first data packet based on the first information. Another possible implementation of step 801 is: obtaining first information based on the first bit sequence and a generator matrix corresponding to the second parity check matrix; and obtaining the first data packet based on the first information. It may be understood that the transmit end may perform, based on a requirement or a preset rule, LDPC encoding on the to-be-encoded bit sequence by using any one of a plurality of parity check matrices that conform to the same base matrix. For a specific process, refer to LDPC code encoding and LDPC encoding in a WLAN described above. A specific manner of performing LDPC encoding on the first bit sequence based on the parity check matrix (for example, the first parity check matrix or the second parity check matrix) is not limited in this application. Because it is a conventional technical means in the art to obtain a corresponding data packet based on encoded information such as the first information, details are not described herein again.

802: The transmit end sends the first data packet.

Specifically, the sending step may include but is not limited to: performing, by the transmit end, processing such as stream parsing (stream parser), constellation mapping (Constellation mapper), and LDPC carrier mapping based on LDPC-encoded bits (that is, the first data packet), or possibly including inverse Fourier transform (inverse discrete Fourier transform, IDFT), for sending on a channel.

Correspondingly, a receive end receives, from the transmit end, a signal (which may also be referred to as the first data packet for ease of description) that carries the encoded first bit sequence. Optionally, the transmit end is a station, and the receive end is an access point. Optionally, the transmit end is an access point, and the receive end is a station.

A possible implementation of step 802 is as follows: The transmit end broadcasts the first data packet. The receive end receives a first channel receive sequence (corresponding to the first data packet) from the transmit end. The first channel receive sequence corresponds to a first signal received by the receive end by using a first channel, that is, a signal received by the receive end after the first data packet sent by the transmit end is transmitted by using the channel.

A possible implementation of step 802 is as follows: The transmit end sends the first data packet to the receive end (corresponding to a unicast mode). The receive end receives a first channel receive sequence (corresponding to the first data packet) from the transmit end.

803: The receive end determines a first log-likelihood ratio (log likelihood rate, LLR) sequence corresponding to the first channel receive sequence, and decodes the first LLR sequence based on the parity check matrix to obtain a first decoding result.

It should be understood that if the transmit end performs LDPC encoding on the first bit sequence based on the first parity check matrix, the receive end decodes the first LLR sequence based on the first parity check matrix; or if the transmit end performs LDPC encoding on the first bit sequence based on the second parity check matrix, the receive end decodes the first LLR sequence based on the second parity check matrix. The receive end may learn, based on control information from the transmit end, the parity check matrix used for decoding the first LLR sequence. The receive end may further learn, in another manner, the parity check matrix used for decoding the first LLR sequence. This is not limited in this application.

The receive end may decode the first LLR sequence based on the first parity check matrix by using any one of hard-decision decoding, soft-decision decoding, or hybrid decoding. This is not limited herein.

804: If decoding succeeds, the receive end outputs the first decoding result.

Step 804 is optional rather than mandatory. Outputting the first decoding result may be: the receive end outputs the first decoding result by using an output device such as a display, a display screen, or an audio device. Optionally, if the receive end incorrectly performs decoding (or fails to perform decoding), the receive end sends retransmission indication information to the transmit end, to request the transmit end to perform retransmission. In addition, if decoding fails, the receive end may store the first LLR sequence, to combine the first LLR sequence with a subsequently received retransmitted LLR sequence for decoding.

In this embodiment of this application, both the first parity check matrix and the second parity check matrix conform to the first base matrix. The first parity check matrix and the second parity check matrix are obtained by extending the first base matrix, so that encoding complexity can be reduced.

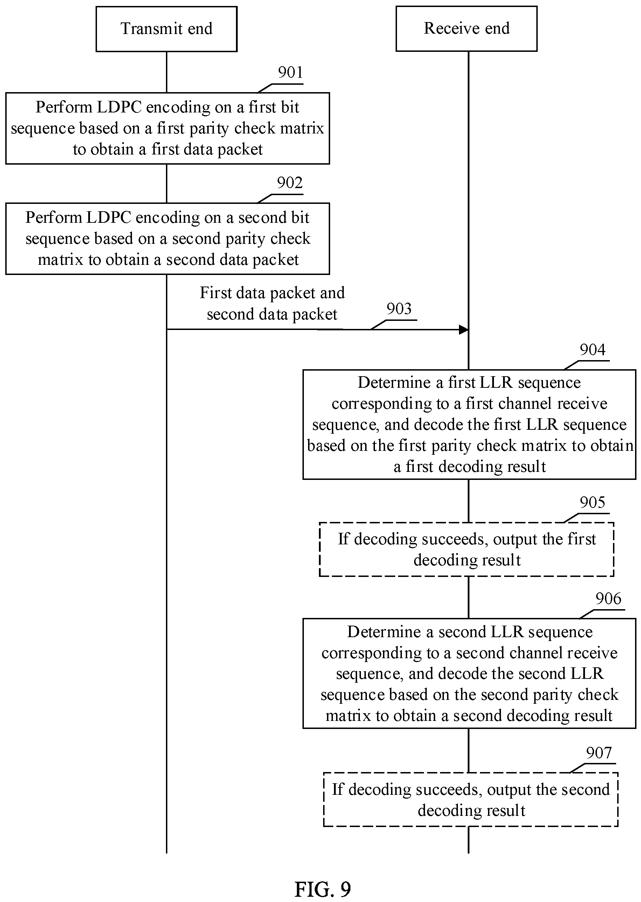

FIG. 9 is an interaction flowchart of another LDPC code encoding method according to this application. As shown in FIG. 9, the method includes the following steps.

901: A transmit end performs LDPC encoding on a first bit sequence based on a first parity check matrix to obtain a first data packet.

For step 901, refer to step 801.

902: The transmit end performs LDPC encoding on a second bit sequence based on a second parity check matrix to obtain a second data packet.

For step 902, refer to step 801. A sequence of step 901 and step 902 is not limited. A code length of the first parity check matrix is different from a code length of the second parity check matrix. Both the first parity check matrix and the second parity check matrix conform to a first base matrix. In other words, both the first parity check matrix and the second parity check matrix are obtained by extending the base matrix or a submatrix of the base matrix. A main principle of this application is to obtain parity check matrices with different code lengths by extending the same base matrix, so as to reduce encoding complexity. The following describes in detail an implementation of obtaining parity check matrices with different code lengths by extending the same base matrix. In this application, code rates of the first parity check matrix and the second parity check matrix are not limited. In this application, another code rate may be obtained by shortening or puncturing a parity check matrix of an LDPC code. For a shortening operation, refer to FIG. 4.

The type of the first data packet may be different from the type of the second data packet. The type of the first data packet and the type of the second data packet may be any two of a short packet, a medium packet, and a long packet. For example, the type of the first data packet is a long packet, and the type of the second data packet is a short packet. For another example, the type of the first data packet is a medium packet, and the type of the second data packet is a long packet. It should be understood that a length of a short packet is less than that of a medium packet, and a length of a medium packet is less than that of a long packet. A length of the first bit sequence is different from a length of the second bit sequence. LDPC encoding needs to be performed on the first bit sequence and the second bit sequence by using parity check matrices with different code lengths. In other words, the first bit sequence and the second bit sequence need to be sent by using different types of data packets. For example, the first bit sequence includes 20 bits (bits), and the second bit sequence includes 1500 bits. The transmit end performs LDPC encoding on the first bit sequence based on the first parity check matrix with a code length of 648 bits to obtain the first data packet. The transmit end performs LDPC encoding on the second bit sequence based on the second parity check matrix with a code length of 1944 bits to obtain the second data packet. The first data packet is a short packet, and the second data packet is a long packet. It can be learned from this example that when sending different types of data packets, the transmit end needs to perform LDPC encoding on the to-be-encoded bit sequences based on parity check matrices with different code lengths.

In a possible implementation, the first parity check matrix and the second parity check matrix are obtained by extending the first base matrix by using a same hardware circuit, and the first parity check matrix and the second parity check matrix correspond to different extension manners or extension parameters. In other words, the transmit end may extend the first base matrix by using the same hardware circuit, to obtain parity check matrices with two or more code lengths. In other words, the transmit end may obtain, by changing or adjusting an extension manner or an extension parameter used by a hardware circuit, parity check matrices with two or more code lengths by extending the first base matrix. For example, a first hardware circuit at the transmit end is configured to perform extension based on the first base matrix to obtain a plurality of parity check matrices; and when the first hardware circuit uses a first extension manner (or a first extension parameter), perform extension based on the first base matrix to obtain the first parity check matrix; or when the first hardware circuit uses a second extension manner (or a second extension parameter), perform extension based on the first base matrix to obtain the second parity check matrix. In a possible implementation provided in this application, the transmit end may extend the first base matrix by using the same hardware circuit, to obtain parity check matrices with two or more code lengths, and encoding complexity is relatively low.

903: The transmit end sends the first data packet and the second data packet.

Optionally, the transmit end sends the first data packet and the second data packet separately, that is, sends the first data packet and the second data packet by using different signals or channels. Alternatively, the transmit end sequentially sends the first data packet and the second data packet.

Correspondingly, the receive end receives, from the transmit end, a signal (which may also be referred to as the first data packet for ease of description) that carries the encoded first bit sequence and a signal (which may also be referred to as the second data packet for ease of description) that carries the encoded second bit sequence. Optionally, the transmit end is a station, and the receive end is an access point. Optionally, the transmit end is an access point, and the receive end is a station.

A possible implementation of step 903 is as follows: The transmit end broadcasts the first data packet and the second data packet. The receive end receives a first channel receive sequence (corresponding to the first data packet) and a second channel receive sequence (corresponding to the second data packet) from the transmit end. The first channel receive sequence corresponds to a first signal received by the receive end by using a first channel, that is, a signal received by the receive end after the first data packet sent by the transmit end is transmitted by using the channel. The second channel receive sequence corresponds to a second signal received by the receive end by using a second channel, that is, a signal received by the receive end after the second data packet sent by the transmit end is transmitted by using the channel.

A possible implementation of step 903 is as follows: The transmit end sends the first data packet and the second data packet to the receive end (corresponding to a unicast mode). The receive end receives the first channel receive sequence (corresponding to the first data packet) and the second channel receive sequence (corresponding to the second data packet) from the transmit end.

904: The receive end determines a first LLR sequence corresponding to the first channel receive sequence, and decodes the first LLR sequence based on the first parity check matrix to obtain a first decoding result.

905: If decoding succeeds, the receive end outputs the first decoding result.

Step 905 is optional rather than mandatory. For step 905, refer to step 804.

906: The receive end determines a second LLR sequence corresponding to the second channel receive sequence, and decodes the second LLR sequence based on the second parity check matrix to obtain a second decoding result.

907: If decoding succeeds, the receive end outputs the second decoding result.

Step 907 is optional rather than mandatory. For step 907, refer to step 804.

In this embodiment of this application, both the first parity check matrix and the second parity check matrix conform to the first base matrix. The transmit end performs LDPC encoding by using parity check matrices that have different code lengths and that conform to the first base matrix, so that encoding complexity can be reduced.

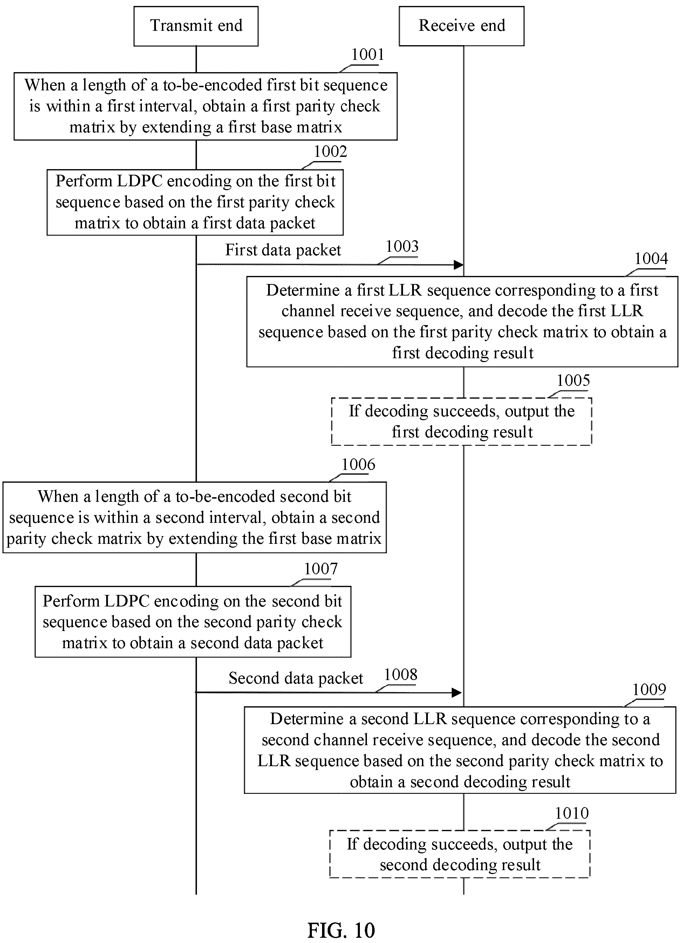

FIG. 10 is an interaction flowchart of another LDPC code encoding method according to an embodiment of this application. An interaction procedure of the method in FIG. 10 is a possible implementation of the method described in FIG. 9. In this implementation, a transmit end obtains a parity check matrix with a required code length by extending a first base matrix and a length of a to-be-encoded bit sequence. This is applicable to sending data packets with different lengths, and reduces encoding complexity.

1001: When a length of a to-be-encoded first bit sequence is within a first interval, a transmit end obtains a first parity check matrix by extending a first base matrix.

The first interval may be an interval configured based on a requirement. This is not limited in this application. The first interval may be less than or equal to 40 bytes (bytes). When a length of any to-be-encoded bit sequence (for example, the first bit sequence) is within the first interval, the transmit end needs to perform LDPC encoding on the bit sequence by using the first parity check matrix with a first code length. The first code length may be 320 bits, 640 bits, 648 bits, or the like. That a length of a to-be-encoded first bit sequence is within a first interval may be understood as a condition that needs to be met before the first parity check matrix is obtained by extending the first base matrix. In other words, that a length of a to-be-encoded first bit sequence is within a first interval is a condition for triggering the transmit end to obtain the first parity check matrix by extending the first base matrix. It should be understood that the transmit end may alternatively obtain the first parity check matrix by extending the first base matrix when another condition is met. For example, when determining that the parity check matrix with the first code length needs to be used for encoding, the transmit end performs extension based on the first base matrix to obtain the first parity check matrix whose code length is the first code length.

1002: The transmit end performs LDPC encoding on the first bit sequence based on the first parity check matrix to obtain a first data packet.

1003: The transmit end sends the first data packet.

Correspondingly, a receive end receives a first channel receive sequence (corresponding to the first data packet) from the transmit end. For step 1003, refer to step 802.

1004: The receive end determines a first LLR sequence corresponding to the first channel receive sequence, and decodes the first LLR sequence based on the first parity check matrix to obtain a first decoding result.

1005: If decoding succeeds, the receive end outputs the first decoding result.

Step 1005 is optional rather than mandatory. For step 1005, refer to step 804.

1006: When a length of a to-be-encoded second bit sequence is within a second interval, the transmit end obtains a second parity check matrix by extending the first base matrix.

When a length of any to-be-encoded bit sequence (for example, the second bit sequence) is within the second interval, the transmit end needs to perform LDPC encoding on the bit sequence by using the second parity check matrix with a second code length. The second code length may be 1280 bits, 1296 bits, 1944 bits, 2560 bits, or the like. This is not limited in this application.

The second interval does not overlap the first interval. In other words, an intersection set of the first interval and the second interval is an empty set. Both the first interval and the second interval are continuous intervals. For example, the first interval is (0, first value], and the second interval is (second value, third value], where the second value is greater than the first value, the third value is greater than the second value, and the first value is greater than 0. For another example, the first interval is (0, first value], and the second interval is (first value, third value], where the second value is greater than the first value, and the first value is greater than 0. The second interval may be greater than 40 bytes. It should be understood that the transmit end may correspondingly set the first interval and the second interval based on an actual requirement. This is not limited in this application.

In a possible implementation, a specific extension factor value of a CPM in a first position in the first parity check matrix is b, an extension factor of the CPM in the first parity check matrix is Z1, a specific extension factor value of a CPM in a first position in the second parity check matrix is (b mod Z), and an extension factor of the CPM in the second parity check matrix is Z2, where Z, Z1, and Z2 are all integers greater than 0, Z1 is greater than or equal to Z, and Z2 is less than Z. The first position may be any position in the first parity check matrix. Elements in same positions in the first parity check matrix and the second parity check matrix are in a one-to-one correspondence. In other words, if a specific extension factor value of a CPM in any position in the first parity check matrix is b, a specific extension factor value of a CPM in a corresponding position in the second parity check matrix is (b mod Z), where mod represents a modulo operation or a remainder operation. Optionally, Z is an integer multiple of 27, for example, 27, 54, or 81. For example, the first base matrix corresponds to an original parity check matrix, an extension factor of a CPM in the original parity check matrix is Z, a specific extension factor value of a CPM in a first position in the original parity check matrix is b, a specific extension factor value of a CPM in a first position in the first parity check matrix is b, an extension factor of the CPM in the first parity check matrix is Z1, a specific extension factor value of a CPM in a first position in the second parity check matrix is (b mod Z), and an extension factor of the CPM in the second parity check matrix is Z2, where Z, Z1, and Z2 are all integers greater than 0, Z1 is greater than or equal to Z, and Z2 is less than Z. Optionally, Z is an integer multiple of 27, for example, 27, 54, or 81. Optionally, the parity check matrix further includes the original parity check matrix. The original parity check matrix corresponding to the base matrix may be the matrix shown in FIG. 6, or may be a WLAN LDPC parity check matrix with a code rate of 1/2, a code length of 1296, and an extension factor of 54, or may be a WLAN LDPC parity check matrix with a code rate of 1/2, a code length of 1944, and an extension factor of 81, or may be another parity check matrix. This is not limited in this application. In this implementation, the specific extension factor value of the circulant permutation matrix CPM in the first position in the first parity check matrix is b, and the specific extension factor value of the CPM in the first position in the second parity check matrix is (b mod Z); and a required parity check matrix can be quickly obtained through extension.

In a possible implementation, a specific extension factor value of a CPM in a first position in the first parity check matrix is b, an extension factor of the CPM in the first parity check matrix is Z3, a specific extension factor value of a CPM in a first position in the second parity check matrix is any one of b, (b+Z), and (b+2Z), and an extension factor of the CPM in the second parity check matrix is Z4, where Z, Z3, and Z4 are all integers greater than 0, Z3 is less than Z, and Z4 is greater than or equal to Z. It should be noted that it needs to be ensured that each element in the second parity check matrix is less than or equal to Z4. The first position may be any position in the first parity check matrix. Optionally, Z and Z4 are both integer multiples of 27. For example, Z is 27, and Z4 is 54 or 81. Elements in same positions in the first parity check matrix and the second parity check matrix are in a one-to-one correspondence. It may be understood that if a specific extension factor value of a CPM in any position in the first parity check matrix is b, a specific extension factor value of a CPM in a corresponding position in the second parity check matrix is any one of b, (b+Z), and (b+2Z). It should be noted that a specific extension factor value in each position in the second parity check matrix is any one of b, (b+Z), and (b+2Z). For example, a specific extension factor value of a CPM in a first position in the first parity check matrix is b, a specific extension factor value of a CPM in a first position in the second parity check matrix is (b+Z), a specific extension factor value of a CPM in a third position in the first parity check matrix is a, and a specific extension factor value of a CPM in a third position in the second parity check matrix is (a+2Z). In this implementation, a required parity check matrix can be quickly obtained through extension.

In a possible implementation, the first base matrix corresponds to an original parity check matrix, an extension factor of a CPM in the original parity check matrix is Z, a specific extension factor value of a CPM in a first position in the original parity check matrix is b, a specific extension factor value of a CPM in a first position in the first parity check matrix is (b mod Z), an extension factor of the CPM in the first parity check matrix is Z3, a specific extension factor value of a CPM in a first position in the second parity check matrix is any one of b, (b+Z), and (b+2Z), and an extension factor of the CPM in the second parity check matrix is Z4, where Z, Z3, and Z4 are all integers greater than 0, Z3 is less than Z, and Z4 is greater than or equal to Z. It should be noted that it needs to be ensured that each element in the first parity check matrix is less than or equal to Z4. Optionally, Z and Z4 are both integer multiples of 27. For example, Z is 27, and Z4 is 54 or 81. In this implementation, a required parity check matrix can be quickly obtained through extension.

1007: The transmit end performs LDPC encoding on the second bit sequence based on the second parity check matrix to obtain a second data packet.

1008: The transmit end sends the second data packet.

Correspondingly, the receive end receives a second channel receive sequence (corresponding to the second data packet) from the transmit end. For step 1008, refer to step 802.

1009: The receive end determines a second LLR sequence corresponding to the second channel receive sequence, and decodes the second LLR sequence based on the second parity check matrix to obtain a second decoding result.

1010: If decoding succeeds, the receive end outputs the second decoding result.

Step 1010 is optional rather than mandatory. For step 1010, refer to step 804.

In actual data sending, the transmit end does not necessarily generate parity check matrices with corresponding code lengths in all intervals. The first interval and the second interval are merely examples. It should be understood that as long as the transmit end generates a parity check matrix with a corresponding code length based on a length of a bit sequence, this behavior falls within the protection scope of this application. This application is not limited to generating parity check matrices with corresponding code lengths in all intervals.

FIG. 10 depicts a method procedure in which the transmit end obtains the first parity check matrix by extending the first base matrix when the length of the to-be-encoded first bit sequence is within the first interval, and obtains the second parity check matrix by extending the first base matrix when the length of the to-be-encoded second bit sequence is within the second interval. It should be understood that FIG. 10 is merely an example in which two parity check matrices (that is, the first parity check matrix and the second parity check matrix) are obtained by extending the first base matrix. The transmit end may obtain three or more parity check matrices by extending the first base matrix, and each parity check matrix may correspond to one interval.

For example, when the length of the to-be-encoded bit sequence is within the first interval, the transmit end obtains the first parity check matrix by extending the first base matrix; when the length of the to-be-encoded bit sequence is within the second interval, the transmit end obtains the second parity check matrix by extending the first base matrix; or when the length of the to-be-encoded bit sequence is within a third interval, the transmit end obtains a third parity check matrix by extending the first base matrix. Code lengths of any two of the first parity check matrix, the second parity check matrix, and the third parity check matrix are different, and any two of the first interval, the second interval, and the third interval do not overlap. For example, the first interval is (0, first value], the second interval is (second value, third value], and the third interval is (third value, fourth value], where the code length of the first parity check matrix is 648 bits, the code length of the second parity check matrix is 1296 bits, and the code length of the third parity check matrix is 1944 bits. The first value is greater than 0, the second value is greater than the first value, the third value is greater than the second value, and the fourth value is greater than the third value. In actual application, the first interval, the second interval, and the third interval may be set based on an actual requirement. This is not limited in this application. FIG. 6 is reused. FIG. 6 shows an example of a first parity check matrix. Refer to FIG. 6. A code length N of the first parity check matrix is 648 (bits), a code rate R is 1/2, and an extension factor Z is 27. In FIG. 6, 0 represents an identity matrix (27×27), an element greater than 0 represents a CPM (27×27), and "-" represents an all-zero matrix (27×27). For example, 22 represents a CPM (27×27) whose specific extension factor value is 22.

For example, when the length of the to-be-encoded bit sequence is within the first interval, the transmit end obtains the first parity check matrix by extending the first base matrix; when the length of the to-be-encoded bit sequence is within the second interval, the transmit end obtains the second parity check matrix by extending the first base matrix; when the length of the to-be-encoded bit sequence is within the third interval, the transmit end obtains the third parity check matrix by extending the first base matrix; or when the length of the to-be-encoded bit sequence is within a fourth interval, the transmit end obtains a fourth parity check matrix by extending the first base matrix. Code lengths of any two of the first parity check matrix, the second parity check matrix, the third parity check matrix, and the fourth parity check matrix are different, and any two of the first interval, the second interval, the third interval, and the fourth interval do not overlap. For example, the first interval is (0, first value], the second interval is (second value, third value], the third interval is (third value, fourth value], and the fourth interval is (fourth value, fifth value], where the code length of the first parity check matrix is 320 bits, the code length of the second parity check matrix is 640 bits, the code length of the third parity check matrix is 1280 bits, and the code length of the fourth parity check matrix is 2560 bits. The first value is greater than 0, the second value is greater than the first value, the third value is greater than the second value, the fourth value is greater than the third value, and the fifth value is greater than the fourth value. In actual application, the first interval, the second interval, the third interval, and the fourth interval may be set based on an actual requirement. This is not limited in this application.

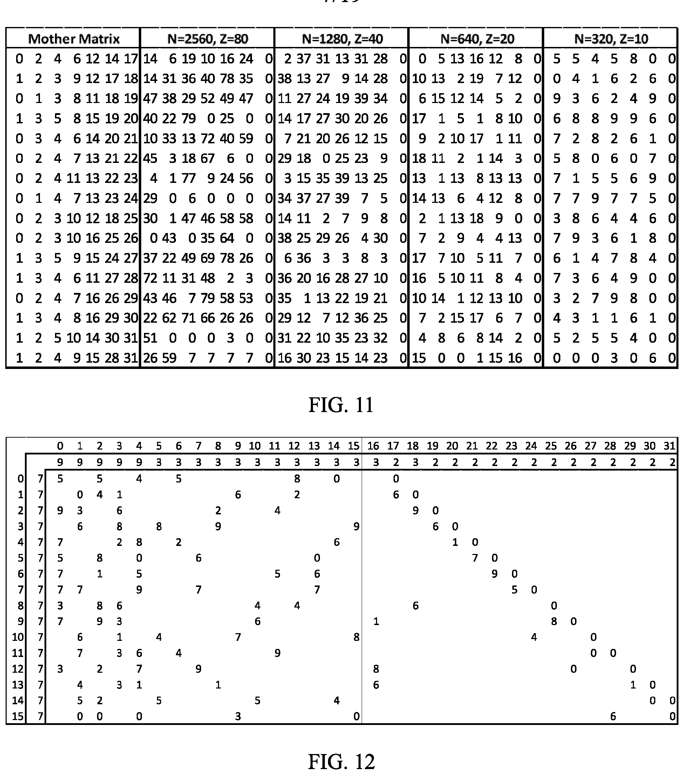

FIG. 11 is an example of a matrix representing a first base matrix and specific extension factor value matrices of four parity check matrices obtained by extending the first base matrix according to an embodiment of this application. In this application, the matrix representing the first base matrix may be considered as the first base matrix. A reason why the first base matrix is not directly written is that the first base matrix is a matrix ($16 \times 32$) and is difficult to present. Similarly, this application does not directly show a parity check matrix ($16 \times 32$) either, but shows a specific extension factor value matrix of the parity check matrix. Because it is difficult to directly present the parity check matrix ($16 \times 32$), and an extension factor of the parity check matrix may represent the parity check matrix, a specific extension factor value matrix of the parity check matrix may be considered as the parity check matrix. Refer to FIG. 11. Each rectangular frame includes one matrix. Five rectangular frames shown in FIG. 11 include the matrix representing the first base matrix, a specific extension factor value matrix of the fourth parity check matrix, a specific extension factor value matrix of the third parity check matrix, a specific extension factor value matrix of the second parity check matrix, and a specific extension factor value matrix of the first parity check matrix sequentially from left to right. The matrix representing the first base matrix may be considered as the first base matrix. In other words, the first base matrix is expressed by the matrix representing the first base matrix. In this embodiment of this application, the first base matrix includes only two types of elements: 0 and 1. The matrix representing the first base matrix may show a position of 1 in each row of the first base matrix, and therefore may represent the first base matrix. In other words, an element in row i of the matrix representing the first base matrix is in a one-to-one correspondence with a position of an element 1 in row i of the first base matrix, where row i is any row. Optionally, if any element in row i of the matrix representing the first base matrix is u, it indicates that an element in row i and column (u+1) of the first base matrix is 1, where row i is any row, and u is an integer from 0 to 31. Refer to FIG. 11. Elements in row 1 of the matrix representing the first base matrix are respectively 0, 2, 4, 6, 12, 14, and 17, indicating that elements in row 1 and column 1, column 3, column 5, column 7, column 13, column 15, and column 18 of the first base matrix are 1, and all elements in row 1 and other columns of the first base matrix are 0; elements in row 2 of the matrix representing the first base matrix are respectively 1, 2, 3, 9, 12, 17, and 18, indicating that elements in row 2 and column 2, column 3, column 4, column 10, column 13, column 18, and column 19 of the first base matrix are 1, and all elements in row 2 and other columns of the first base matrix are 0, and so on. It can be learned that the matrix representing the first base matrix may be considered as the first base matrix itself.

Refer to FIG. 11. An extension factor Z of a CPM in the first parity check matrix is 10 and a code length N is 320; an extension factor Z of a CPM in the second parity check matrix is 20 and a code length N is 640; an extension factor Z of a CPM in the third parity check matrix is 40 and a code length N is 1280; an extension factor Z of a CPM in the fourth parity check matrix is 80 and a code length N is 2560; and the first parity check matrix, the second parity check matrix, the third parity check matrix, and the fourth parity check matrix all conform to the first base matrix. The following uses the first parity check matrix as an example to describe why a specific extension factor value matrix of a parity check matrix may be considered as the parity check matrix. An element in a second position (any position) in row j of the matrix representing the first base matrix is p, an element in a second position in row j of a first specific value matrix (that is, the specific extension factor value matrix of the first parity check matrix) is q, and an element in row j and column (p+1) of the first parity check matrix is q. 0 in the first parity check matrix represents an identity matrix with a size of ($10 \times 10$), and an element greater than 0 in the first parity check matrix represents a specific extension factor value of a CPM with a size of ($10 \times 10$). FIG. 12 is an example of a first parity check matrix according to an embodiment of this application. The first parity check matrix shown in FIG. 12 is a parity check matrix represented by the specific extension factor value matrix of the first parity check matrix in FIG. 11. In other words, the specific extension factor value matrix of the first parity check matrix in FIG. 11 may be extended to obtain the first parity check matrix shown in FIG. 12. In FIG. 12, 0, 1, ..., 31 successively correspond to column 1 to column 32 of the first parity check matrix, 0, 1, ..., 15 successively correspond to row 1 to row 16 of the first parity check matrix, an element in column 2 represents a row weight of a corresponding row, and an element in row 2 represents a column weight of a corresponding column. In FIG. 12, a left part ($16 \times 16$) of the matrix corresponds to an information part, and a right part ($16 \times 16$) of the matrix is a parity check part. Refer to FIG. 11 and FIG. 12. A leftmost rectangular frame in FIG. 11 includes the matrix (which may be referred to as matrix 1 below) representing the first base matrix, and a rightmost rectangular frame in FIG. 11 includes the first specific value matrix. Matrix 1 and the first specific value matrix have a same size, and elements in same positions in matrix 1 and the first specific value matrix are in a one-to-on correspondence. It can be learned from the description in the foregoing paragraph that elements in row 1 of matrix 1 (16×32) are respectively 0, 2, 4, 6, 12, 14, and 17, indicating that elements in row 1 and column 1, column 3, column 5, column 7, column 13, column 15, and column 18 of matrix 1 are 1. In this case, an element in row 1 and column 1 of matrix 1 is 0, indicating that a value exists in row 1 and column 1 of the first specific value matrix. With reference to an element of 5 in the first specific value matrix, it can be learned that an element in row 1 and column 1 of the first specific value matrix is 5, indicating that an element in row 1 and column 1 of the first parity check matrix is 5, that is, a CPM with a size of (10×10) and a cyclic shift value of 5 in a position of row 1 and column 1 of the first parity check matrix. An element in row 1 and column 2 of matrix 1 is 2, indicating that a value exists in row 1 and column 2 of the first specific value matrix. With reference to an element of 5 in the first specific value matrix, it can be learned that an element in row 1 and column 2 of the first specific value matrix is 5, indicating that an element in row 1 and column 3 of the first parity check matrix is 5, that is, a CPM with a size (10×10) and a cyclic shift value of 5 is in a position in row 1 and column 3 of the first parity check matrix. An element in row 1 and column 3 of matrix 1 is 4, indicating that a value exists in row 1 and column 3 of the first specific value matrix. With reference to an element of 4 in the first specific value matrix, it can be learned that 4 is in row 1 and column 3 of the first specific value matrix, indicating that an element in row 1 and column 5 of the first parity check matrix is 4. The rest may be inferred by analogy. It should be understood that a specific extension factor value matrix of any parity check matrix in combination with a base matrix to which the parity check matrix conforms may represent the parity check matrix. It can be learned that the first specific value matrix may be considered as the first parity check matrix itself. Similarly, a specific extension factor value matrix of any parity check matrix may be considered as the parity check matrix.

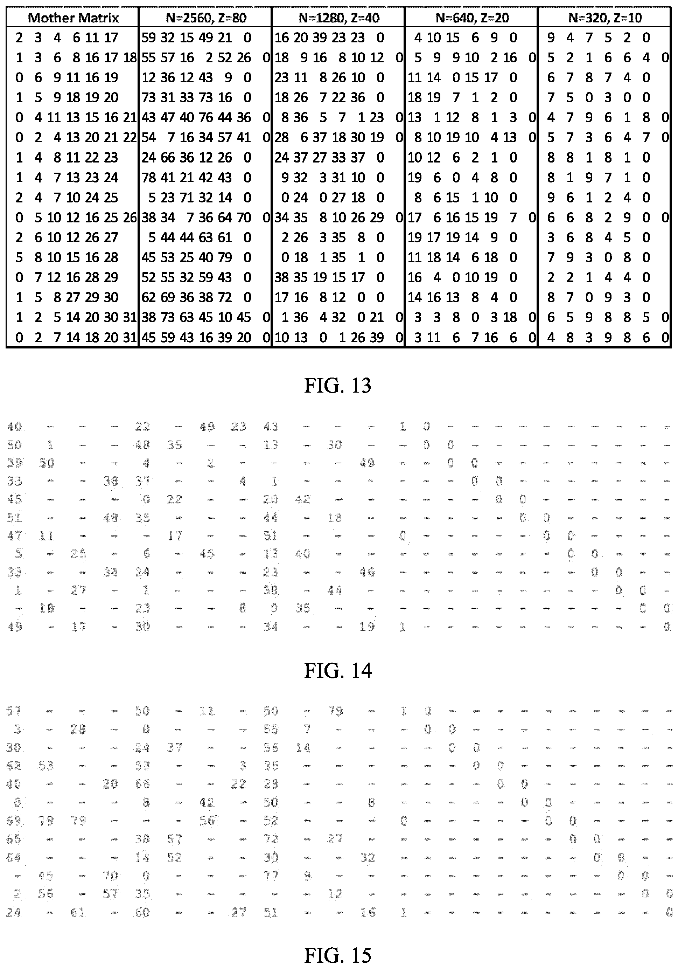

FIG. 13 is an example of another matrix representing a first base matrix and specific extension factor value matrices of four parity check matrices obtained by extending the first base matrix according to an embodiment of this application. Refer to FIG. 13. Each rectangular frame includes one matrix. Five rectangular frames shown in FIG. 13 include the matrix representing the first base matrix, a specific extension factor value matrix of the fourth parity check matrix, a specific extension factor value matrix of the third parity check matrix, a specific extension factor value matrix of the second parity check matrix, and a specific extension factor value matrix of the first parity check matrix sequentially from left to right. The matrix representing the first base matrix may be considered as the first base matrix. The specific extension factor value matrix of the fourth parity check matrix in combination with the matrix representing the first base matrix may represent the fourth parity check matrix. The specific extension factor value matrix of the third parity check matrix in combination with the matrix representing the first base matrix may represent the third parity check matrix. The specific extension factor value matrix of the second parity check matrix in combination with the matrix representing the first base matrix may represent the second parity check matrix. The specific extension factor value matrix of the first parity check matrix in combination with the matrix representing the first base matrix may represent the first parity check matrix.

In this embodiment of this application, the transmit end obtains a parity check matrix with a required code length by extending the first base matrix and the length of the to-be-encoded bit sequence. This is applicable to sending data packets with different lengths, and reduces encoding complexity.

The foregoing describes in detail the LDPC encoding method provided in this application. The following mainly describes base matrices provided in this application and examples of some parity check matrices extended from these base matrices.

The base matrices provided in this application may be extended to parity check matrices of LDPC codes with various code lengths as required. As described above, the parity check matrices of the LDPC codes with various code lengths can be obtained by replacing 1 in the base matrices with CPMs of various cyclic factors and replacing 0 with all-zero square matrices of corresponding sizes. In other words, a plurality of parity check matrices of LDPC codes may be obtained by using one base matrix. Sizes of these parity check matrices and extension factors of all CPMs may be different, but the parity check matrices and the CPMs correspond to the same base matrix.

It should be noted that base matrices obtained by performing various row-column permutations on the base matrix provided in this application are equivalent to the base matrix provided in this application. In other words, the base matrices obtained by performing the row-column permutations on the base matrix provided in this application also belong to the base matrices protected in this application. The various row-column permutations of the base matrix mean that one or more elements in the base matrix are replaced with another element or other elements. In other words, after being replaced with the another element or the other elements, the one or more elements in the base matrix are equivalent to the base matrix. In other words, replacing the one or more elements in the base matrix with the another element or the other elements may also be considered as the base matrix. In this application, the row-column permutation of the base matrix may include any one of the following: One or more elements in a row of the base matrix are replaced with another element or other elements, one or more elements in a column of the base matrix are replaced with another element or other elements, a plurality of elements in different rows of the base matrix are replaced with other elements, a plurality of elements in different columns of the base matrix are replaced with other elements, locations of a plurality of rows in the base matrix are changed, and locations of a plurality of columns in the base matrix are changed. For example, locations of two columns in the base matrix are interchanged. Replacing one element with another element may be understood as replacing the element with any element different from the element. For example, one or more elements 0 in the base matrix are replaced with an element 1. For another example, one or more elements 1 in the base matrix are replaced with an element.

This application provides two designs in which parity check matrices with different code lengths are obtained by extending a single base matrix. In a first solution, parity check matrices with different code lengths are obtained by extending a base matrix corresponding to an existing parity check matrix. For example, parity check matrices with different code lengths are obtained by extending a base matrix corresponding to a parity check matrix whose code rate is 1/2 in an LDPC code in the IEEE 802.11n standard. In a second solution, a plurality of factors such as performance, a decoding convergence speed, and decoding complexity of an LDPC code are comprehensively considered, and several groups of base matrices and corresponding parity check matrices of LDPC codes with low complexity and fast decoding convergence are designed.

In the first design provided in this application, starting from a base matrix to which an existing parity check matrix conforms, a plurality of parity check matrices based on the base matrix are obtained by directly extending the base matrix by using different extension factors Z. A parity check matrix of a WLAN LDPC code with R = 1/2, N = 648, and Z = 27 shown in FIG. 6 is used as an example. A base matrix to which the parity check matrix conforms is a corresponding matrix (12×24) obtained by replacing all non '-' in the parity check matrix with 1 and replacing all "-" in the parity check matrix with 0. The base matrix is extended by using Z = 27, and a parity check matrix (324×648) may be obtained after the extension. Each non-zero element in the base matrix corresponds to a specific extension factor value in the parity check matrix.

The following shows some examples of the first base matrix provided in this application.

Base matrix 1:

```
            1 0 0 0 1 1 0 0 1 0 0 1 1 1 0 0 0
 0 0 0 0 0 0 0 0
            1 1 0 0 1 0 1 1 1 0 0 0 0 1 1 0 0
 0 0 0 0 0 0 0 0
            1 0 1 0 1 0 0 0 1 0 1 0 0 0 1 1 0
 0 0 0 0 0 0 0 0
            1 0 0 1 1 0 0 0 1 1 0 0 0 0 0 1 1
 0 0 0 0 0 0 0 0
            1 0 0 0 1 0 0 0 1 0 1 1 0 0 0 0 1
 1 0 0 0 0 0 0 0
            1 0 1 1 1 0 1 0 1 0 0 0 0 0 0 0 0
 1 1 0 0 0 0 0 0
            1 0 0 0 1 0 0 0 1 1 0 0 1 0 0 0 0
 0 1 1 0 0 0 0 0
            1 1 0 0 1 0 1 0 1 0 0 0 0 0 0 0 0
 0 0 1 1 0 0 0 0
            1 1 0 1 1 1 0 0 1 0 0 0 0 0 0 0 0
 0 0 0 1 1 0 0 0
            1 0 0 0 1 0 0 0 1 0 1 1 0 0 1 0 0
 0 0 0 0 1 1 0 0
            1 0 1 0 1 1 0 1 1 0 0 0 0 0 0 1 0
 0 0 0 0 0 1 1 0
            1 0 0 0 1 0 0 1 1 1 0 0 1 0 0 0 0
 0 0 0 0 0 0 0 1
```

FIG. 6 shows an example of a parity check matrix obtained by extending base matrix 1.

Base matrix 2:

```
            1 0 0 0 1 0 1 1 1 0 0 0 1 1 0 0 0
 0 0 0 0 0 0 0 0
            1 1 0 0 1 1 0 0 1 0 1 0 0 1 1 0 0
 0 0 0 0 0 0 0 0
            1 1 0 0 1 0 1 0 0 0 0 1 0 0 1 1 0
 0 0 0 0 0 0 0 0
            1 0 0 1 1 0 0 1 1 0 0 0 0 0 0 1 1
 0 0 0 0 0 0 0 0
            1 0 0 0 1 1 0 0 1 1 0 0 0 0 0 0 1
 1 0 0 0 0 0 0 0
            1 0 0 1 1 0 0 0 1 0 1 0 0 0 0 0 0
 1 1 0 0 0 0 0 0
```

```
1 1 0 0 0 1 0 0 1 0 0 0 1 0 0 0 0
0 1 1 0 0 0 0
1 0 1 0 1 0 1 0 1 1 0 0 0 0 0 0 0
0 0 1 1 0 0 0
1 0 0 1 1 0 0 0 1 0 0 1 0 0 0 0 0
0 0 0 1 1 0 0
1 0 1 0 1 0 0 0 1 0 1 0 0 0 1 0 0
0 0 0 0 1 1 0
0 1 0 0 1 0 0 1 1 1 0 0 0 0 0 1 0
0 0 0 0 0 1 1
1 0 1 0 1 0 0 0 1 0 0 1 1 0 0 0 0
0 0 0 0 0 0 1
```

FIG. 14 is an example of a parity check matrix obtained by extending base matrix 2 according to this application. In FIG. 14, "-" represents an all-zero matrix (54×54), 0 represents an identity matrix (54×54), and an element greater than 0 represents a specific extension factor value of a CPM (54×54).

Base matrix 3:

```
1 0 0 0 1 0 1 0 1 0 1 0 1 1 0 0 0
0 0 0 0 0 0 0
1 0 1 0 1 0 0 0 1 1 0 0 0 1 1 0 0
0 0 0 0 0 0 0
1 0 0 0 1 1 0 0 1 1 0 0 0 0 1 1 0
0 0 0 0 0 0 0
1 1 0 0 1 0 0 1 1 0 0 0 0 0 0 1 1
0 0 0 0 0 0 0
1 0 0 1 1 0 0 1 1 0 0 0 0 0 0 0 1
1 0 0 0 0 0 0
1 0 0 0 1 0 1 0 1 0 0 1 0 0 0 0 0
1 1 0 0 0 0 0
1 1 1 0 0 0 1 0 1 0 0 0 1 0 0 0 0
0 1 1 0 0 0 0
1 0 0 0 1 1 1 0 1 0 1 0 1 0 0 0 0
0 0 1 1 0 0 0
1 0 0 0 1 1 0 0 1 0 0 1 0 0 0 0 0
0 0 0 1 1 0 0
0 1 0 1 1 0 0 0 1 1 0 0 0 0 1 0 0
0 0 0 0 1 1 0
1 1 0 1 1 0 0 0 0 0 0 1 0 0 0 0 1 0
0 0 0 0 0 1 1
1 0 1 0 1 0 0 1 1 0 0 1 1 0 0 0 0
0 0 0 0 0 0 1
```

FIG. 15 is an example of a parity check matrix obtained by extending base matrix 2 according to this application. In FIG. 15, "-" represents an all-zero matrix (81×81), 0 represents an identity matrix (81×81), and an element greater than 0 represents a specific extension factor value of a CPM (81×81).

The foregoing base matrix 1, base matrix 2, and base matrix 3 are base matrices corresponding to three existing parity check matrices. In this application, the first base matrix may be a base matrix to which any existing parity check matrix conforms. Examples are not provided herein again.

Matrix 10 representing base matrix 4 is:

```
0 2 4 6  12 14 17
1 2 3 9  12 17 18
0 1 3 8  11 18 19
1 3 5 8  15 19 20
0 3 4 6  14 20 21
0 2 4 7  13 21 22
0 2 4 11 13 22 23
0 1 4 7  13 23 24
0 2 3 10 12 28 25
0 2 3 10 16 25 26
1 3 5 9  15 24 27
1 3 4 6  11 27 28
0 2 4 7  16 26 29
1 3 4 8  16 29 30
1 2 5 10 14 30 31
1 2 4 9  15 28 31
```

Matrix 10 may represent base matrix 4 (12×32). As described above, the matrix representing the first base matrix may be considered as the first base matrix. Similarly, matrix 10 representing base matrix 4 may be considered as base matrix 4. Details are not described herein again.

Specific extension factor value matrix 41 corresponding to parity check matrix 41 extended from base matrix 4 is:

```
14  6  19 10 16 24  0
14 31 36 40 78 35  0
47 38 29 52 49 47  0
40 22 79  0 25  0  0
10 33 13 72 40 59  0
45  3 18 67  6  0  0
4  1 77  9 24 56  0
29  0  6  0  0  0  0
30  1 47 46 58 58  0
0 43  0 35 64  0  0
37 22 49 69 78 26  0
72 11 31 48  2  3  0
43 46  7 79 58 53  0
22 62 71 66 26 26  0
51  0  0  0  3  0  0
26 59  7  7  7  7  0
```

Specific extension factor value matrix 41 represents parity check matrix 41. As described above, a specific extension factor value matrix of any parity check matrix may be considered as the parity check matrix. Similarly, specific extension factor value matrix 41 may be considered as parity check matrix 41. Details are not described herein again.

Specific extension factor value matrix 42 corresponding to parity check matrix 42 extended from base matrix 4 is:

```
2 37 31 13 31 28  0
38 13 27  9 14 28  0
11 27 24 19 39 34  0
14 17 27 30 20 26  0
7 21 20 26 12 15  0
29 18  0 25 23  9  0
3 15 35 39 13 25  0
34 37 27 39  7  5  0
14 11  2  7  9  8  0
38 25 29 26  4 30  0
6 36  3  3  8  3  0
36 20 16 28 27 10  0
35  1 13 22 19 21  0
29 12  7 12 36 25  0
31 22 10 35 23 32  0
16 30 23 15 14 23  0
```

Specific extension factor value matrix 42 represents parity check matrix 42.

Specific extension factor value matrix 43 corresponding to parity check matrix 43 extended from base matrix 4 is:

```
0  5 13 16 12  8  0
10 13  2 19  7 12  0
6 15 12 14  5  2  0
17  1  5  1  8 10  0
9  2 10 17  1 11  0
18 11  2  1 14  3  0
13  1 13  8 13 13  0
14 13  6  4 12  8  0
2  1 13 18  9  0  0
7  2  9  4  4 13  0
17  7 10  5 11  7  0
16  5 10 11  8  4  0
10 14  1 12 13 10  0
7  2 15 17  6  7  0
4  8  6  8 14  2  0
15  0  0  1 15 16  0
```

Specific extension factor value matrix 43 represents parity check matrix 43.

Specific extension factor value matrix 44 corresponding to parity check matrix 44 extended from base matrix 4 is:

```
5  5  4  5  8  0  0
0  4  1  6  2  6  0
```

```
9 3 6 2 4 9 0
6 8 8 9 9 6 0
7 2 8 2 6 1 0
5 8 0 6 0 7 0
7 1 5 5 6 9 0
7 7 9 7 7 5 0
3 8 6 4 4 6 0
7 9 3 6 1 8 0
6 1 4 7 8 4 0
7 3 6 4 9 0 0
3 2 7 9 8 0 0
4 3 1 1 6 1 0
5 2 5 5 4 0 0
0 0 0 3 0 6 0
```

Specific extension factor value matrix 44 represents parity check matrix 44.

Matrix 20 representing base matrix 5 is:

```
2 3 4 6 11 17
1 3 6 8 16 17 18
0 6 9 11 16 19
1 5 9 18 19 20
0 4 11 13 15 16 21
0 2 4 13 20 21 22
1 4 8 11 22 23
1 4 7 13 23 24
2 4 7 10 24 25
0 5 10 12 16 25 26
2 6 10 12 26 27
5 8 10 15 16 28
0 7 12 16 28 29
1 5 8 27 29 30
1 2 5 14 20 30 31
0 2 7 14 18 20 31
```

Matrix 20 may represent base matrix 5 (12×32). As described above, the matrix representing the first base matrix may be considered as the first base matrix. Similarly, matrix 20 representing base matrix 5 may be considered as base matrix 5. Details are not described herein again.

Specific extension factor value matrix 51 corresponding to parity check matrix 51 extended from base matrix 5 is:

```
59 32 15 49 21 0
55 57 16 2 52 26 0
12 36 12 43 9 0
73 31 33 73 16 0
43 47 40 76 44 36 0
54 7 16 34 57 41 0
24 66 36 12 26 0
78 41 21 42 43 0
5 23 71 32 14 0
38 34 7 36 64 70 0
5 44 44 63 61 0
45 53 25 40 79 0
52 55 32 59 43 0
62 69 36 38 72 0
38 73 63 45 10 45 0
45 59 43 16 39 20 0
```

Specific extension factor value matrix 51 represents parity check matrix 51.

Specific extension factor value matrix 52 corresponding to parity check matrix 52 extended from base matrix 5 is:

```
16 20 39 23 23 0
18 9 16 8 10 12 0
23 11 8 26 10 0
18 26 7 22 36 0
8 36 5 7 1 23 0
28 6 37 18 30 19 0
24 37 27 33 37 0
9 32 3 31 10 0
0 24 0 27 18 0
34 35 8 10 26 29 0
2 26 3 35 8 0
```

```
0  18  1  35  1  0
38 35  19 15  17 0
17 16  8  12  0  0
1  36  4  32  0  21 0
10 13  0  1  26 39 0
```

Specific extension factor value matrix 52 represents parity check matrix 52.

Specific extension factor value matrix 53 corresponding to parity check matrix 53 extended from base matrix 5 is:

```
4  10 15 6  9  0
5  9  9  10 2  16 0
11 14 0  15 17 0
18 19 7  1  2  0
13 1  12 8  1  3  0
8  10 19 10 4  13 0
10 12 6  2  1  0
19 6  0  4  8  0
8  6  15 1  10 0
17 6  16 15 19 7  0
19 17 19 14 9  0
11 18 14 6  18 0
16 4  0  10 19 0
14 16 13 8  4  0
3  3  8  0  3  18 0
3  11 6  7  16 6  0
```

Specific extension factor value matrix 53 represents parity check matrix 53.

Specific extension factor value matrix 54 corresponding to parity check matrix 54 extended from base matrix 5 is:

```
9  4  7  5  2  0
5  2  1  6  6  4  0
6  7  8  7  4  0
7  5  0  3  0  0
4  7  9  6  1  8  0
5  7  3  6  4  7  0
8  8  1  8  1  0
8  1  9  7  1  0
9  6  1  2  4  0
6  6  8  2  9  0  0
3  6  8  4  5  0
7  9  3  0  8  0
2  2  1  4  4  0
8  7  0  9  3  0
6  5  9  8  8  5  0
4  8  3  9  8  6  0
```

Specific extension factor value matrix 51 represents parity check matrix 54.

Base matrix 1 to base matrix 5 are merely some examples rather than all examples of the first base matrix provided in this application. It should be understood that base matrices obtained by performing row-column permutations on the base matrix provided in this application also belong to the base matrices protected in this application. Similarly, the parity check matrices obtained by extending the base matrix shown above are merely some examples rather than all examples. It should be noted that the first base matrix provided in this application may include H rows or M columns of any one of base matrix 1 to base matrix 3, where H is an integer from 1 to 12, and M is an integer from 1 to 24. The H rows may be continuous or discontinuous. The M columns may be continuous or discontinuous. The first base matrix provided in this application may include L rows or F columns in base matrix 4 or base matrix 5, where L is an integer from 1 to 12, and F is an integer from 1 to 32. The L rows may be continuous or discontinuous. The F columns may be continuous or discontinuous. In other words, the first base matrix may include some rows or some columns of any one of base matrix 1 to base matrix 5.

Similarly, the parity check matrix provided in this application may include some rows or some columns of any one of parity check matrix 41, parity check matrix 42, parity check matrix 43, parity check matrix 44, parity check matrix 51, parity check matrix 52, parity check matrix 53, and parity check matrix 54. This application not only protects the entire base matrix and parity check matrix that are provided, but also protects some rows and some columns in the base matrix and some rows and some columns in the parity check matrix.

The following describes possible implementations of obtaining parity check matrices with different code lengths by extending a same base matrix.

Manner 1

The transmit end obtains parity check matrix 0 (the foregoing original parity check matrix) by extending the first base matrix. An extension factor of parity check matrix 0 is Z, for example, Z = 27. If parity check matrix 1 whose extension factor is Z1 (greater than or equal to Z) needs to be obtained, a specific extension factor value in parity check matrix 0 is used as a specific extension factor value in a corresponding position in parity check matrix 1. If parity check matrix 2 whose extension factor is Z2 (less than Z) needs to be obtained, a value obtained by performing a modulo-Z operation on a specific extension factor value in parity check matrix 0 is used as a specific extension factor value in a corresponding position in parity check matrix 2. Parity check matrix 1 may be the first parity check matrix, and parity check matrix 2 may be the second parity check matrix. Both parity check matrix 1 and parity check matrix 2 conform to the first base matrix. Both parity check matrix 1 and parity check matrix 2 may be considered as parity check matrices obtained by extending the first base matrix. In this application, elements in same positions in a plurality of parity check matrices obtained by extending the same base matrix are in a one-to-one correspondence. For example, by extending the first base matrix, the transmit end obtains parity check matrix 0, for example, the matrix shown in FIG. 6. Each element in parity check matrix 0 is a matrix (Z×Z), and a specific extension factor value in parity check matrix 0 is used as a specific extension factor value in a corresponding position in parity check matrix 1. A difference between parity check matrix 1 and parity check matrix 0 lies in that each element in parity check matrix 1 is a matrix (Z1×Z1), where Z1 is greater than Z. In this example, the matrix shown in FIG. 6 may represent parity check matrix 1 and parity check matrix 0. For another example, by extending the first base matrix, the transmit end obtains parity check matrix 0, for example, the matrix shown in FIG. 6. Each element in parity check matrix 0 is a matrix (Z×Z), and a value obtained by performing a modulo-Z operation on a specific extension factor value in parity check matrix 0 is used as a specific extension factor value in a corresponding position in parity check matrix 2. For example, a specific extension factor value in parity check matrix 0 is b, and a specific extension factor value in a corresponding position in parity check matrix 2 is (b mod Z). In this implementation, the transmit end may first perform extension to obtain parity check matrix 0, and then perform simple transformation based on parity check matrix 0 to obtain a parity check matrix with a required extension factor. It can be learned that in this implementation, a same extension operation is performed when the transmit end extends the first base matrix by using any extension factor. Because there is no need to perform different extension operations, encoding complexity is relatively low.

Manner 2

The transmit end obtains parity check matrix 0 by extending the first base matrix. An extension factor of parity check matrix 0 is Z, for example, Z = 27. If parity check matrix 1 whose extension factor is Z1 (greater than or equal to Z) needs to be obtained, a specific extension factor value in parity check matrix 0, plus an integer multiple of Z, is used as a specific extension factor value in a corresponding position in parity check matrix 1. For example, a specific extension factor value in parity check matrix 0 is b, and a specific extension factor value in a corresponding position in parity check matrix 1 is b, (b+Z), or (b+2Z). Herein, parity check matrix 0 may be the first parity check matrix, and parity check matrix 1 may be the second parity check matrix. Both parity check matrix 0 and parity check matrix 1 conform to the first base matrix. In manner 2, the extension factor Z may be a minimum extension factor that may be used by the transmit end to extend the first base matrix. In other words, an extension factor of a CPM in the parity check matrix that needs to be obtained by the transmit end is greater than or equal to Z. Therefore, there is no need to obtain a parity check matrix whose extension factor is less than Z. In this implementation, the transmit end may first perform extension to obtain parity check matrix 0, and then perform simple transformation based on parity check matrix 0 to obtain a parity check matrix with a required extension factor. It can be learned that in this implementation, a same extension operation is performed when the transmit end extends the first base matrix by using any extension factor. Because there is no need to perform different extension operations, encoding complexity is relatively low.

Manner 3

The transmit end obtains parity check matrix 0 by extending the first base matrix. An extension factor of parity check matrix 0 is Z, for example, Z = 27. If parity check matrix 3 whose extension factor is Z3 (less than Z) needs to be obtained, a value obtained by performing a modulo-Z operation on a specific extension factor value in parity check matrix 0 is used as a specific extension factor value in a corresponding position in parity check matrix 3. For example, a specific extension factor value in parity check matrix 0 is b, and a specific extension factor value in a corresponding position in parity check matrix 3 is (b mod Z). If parity check matrix 4 whose extension factor is Z4 (greater than or equal to Z) needs to be obtained, a specific extension factor value in parity check matrix 0, plus an integer multiple of Z, is used as a specific extension factor value in a corresponding position in parity check matrix 4. For example, a specific extension factor value in parity check matrix 0 is b, and a specific extension factor value in a corresponding position in parity check matrix 4 is b, (b+Z), or (b+2Z). Parity check matrix 3 may be the first parity check matrix, and parity check matrix 4 may be the second parity check matrix. Both parity check matrix 3 and parity check matrix 4 conform to the first base matrix. Both parity check matrix 3 and parity check matrix 4 may be considered as parity check matrices obtained by extending the first base matrix. It should be noted that each element in parity check matrix 4 cannot be greater than Z1. In this implementation, the transmit end may first perform extension to obtain parity check matrix 0, and then perform simple transformation based on parity check matrix 0 to obtain a parity check matrix with a required extension factor. It can be learned that in this implementation, a same extension operation is performed when the transmit end extends the first base matrix by using any extension factor. Because there is no need to perform different extension operations, encoding complexity is relatively low.

This application describes a manner in which the transmit end obtains a plurality of parity check matrices by extending the first base matrix. It should be understood that the receive end may obtain a plurality of parity check matrices by extending the first base matrix in a similar manner. Details are not described herein again.

In the second solution provided in this application, a plurality of factors such as performance, a decoding convergence speed, and decoding complexity of an LDPC code are comprehensively considered, and several groups of base matrices and corresponding parity check matrices of LDPC codes with low complexity and fast decoding convergence are designed. In this application, the base matrix of the LDPC code may be designed based on a quasi-regular check degree, that is, a weight (a quantity of non-zero elements) of every row of the base matrix has only two values: d and d+1, where d is an integer greater than 0, for example, d = 7. This design can improve processing efficiency of a check node in an LDPC decoding procedure, that is, no resource waste is caused. In addition, because a decoding delay or complexity is highly correlated with a maximum degree of the check node, the maximum degree of the check node is minimized as much as possible (for example, the foregoing d+1) in this application. The maximum degree of the check node is a maximum quantity of edges of the check node or a maximum row weight of the parity check matrix.

In addition, for degree distribution optimization of variable nodes, to balance factors such as encoding performance and complexity, two control variables are introduced in this application: an average variable node degree and a slope (slope). By adjusting the two control variables, the base matrix and the parity check matrix provided in this application can effectively balance factors such as the performance, decoding convergence speed, and complexity of the designed LDPC code. The average variable node degree is an average column weight of the parity check matrix, that is, an average quantity of non-zero elements included in each column. The slope herein is a fitting slope of an EBP-GEXIT chart curve of the designed LDPC code. For a specific principle and description, refer to document [1].

[1] G. Montorsi, "Design of LDPC codes with tunable slope of their EXIT charts," in Turbo Codes and Iterative Information Processing (ISTC), 2016 9th International Symposium on. IEEE, 2016, pp. 126-130.

In this application, the decoding complexity is expressed by using an average variable node degree ($\eta$). In this case, specific complexity of iterative LDPC decoding may be expressed by using a product of an average quantity of iterations and the decoding complexity: $C \propto \eta \cdot n_{it}$. C represents an order of magnitude of approximate decoding operation complexity, $\eta$ represents an average variable node degree, and $n_{it}$ represents an average quantity of iterations. To describe a basic design idea of this application, the following uses LDPC codes (that is, parity check matrices) with code lengths of 320 bits and 640 bits as examples to describe in detail different LDPC codes (corresponding to a base matrix) designed by using different control variables (average variable node degrees and slopes), and provides signal-to-noise ratios (signal noise ratio, SNR) required for performance of the LDPC codes to reach FER = $10^{-2}$ and FER = $10^{-3}$ in 5, 15, and 25 iterations of decoding. Table 1 shows an SNR required for performing five iterations of decoding based on a parity check matrix with a code length of n = 320 bits to reach FER = $10^{-3}$. Table 2 shows an SNR required for performing 25 iterations of decoding based on a parity check matrix with a code length of n = 640 bits to reach FER = $10^{-3}$.

**Table 1**

| Slope | 3.00 | 3.10 | 3.20 | 3.30 | 3.40 | 3.50 | 3.60 | 3.70 | 3.80 | 3.90 |
|---|---|---|---|---|---|---|---|---|---|---|
| -0.2 | 3.34 | 3.19 | 3.29 | 3.19 | 3.23 | 3.21 | 3.21 | 3.20 | 3.14 | 3.14 |
| -0.15 | 3.34 | 3.43 | 3.23 | 3.18 | 3.23 | 3.23 | 3.16 | 3.16 | 3.17 | 3.23 |
| -0.1 | 3.38 | 3.23 | 3.26 | 3.27 | 3.23 | 3.23 | 3.18 | 3.18 | 3.18 | 3.18 |
| -0.05 | 3.24 | 3.40 | 3.25 | 3.23 | 3.23 | 3.25 | 3.24 | 3.24 | 3.24 | 3.24 |
| 0 | 3.24 | 3.20 | 3.32 | 3.24 | 3.14 | 3.16 | 3.10 | 3.15 | 3.10 | 3.15 |
| 0.1 | 3.57 | 3.57 | 3.39 | 3.39 | 3.39 | 3.39 | 3.39 | 3.39 | 3.39 | 3.39 |
| 0.2 | 3.48 | 3.48 | 3.48 | 3.48 | 3.48 | 3.48 | 3.48 | 3.48 | 3.48 | 3.48 |

**Table 2**

| Slope | 3.00 | 3.10 | 3.20 | 3.30 | 3.40 | 3.50 | 3.60 | 3.70 | 3.80 | 3.90 |
|---|---|---|---|---|---|---|---|---|---|---|
| -0.2 | 2.28 | 2.16 | 2.16 | 2.18 | 2.22 | 2.25 | 2.24 | 2.24 | 2.19 | 2.19 |
| -0.15 | 2.28 | 2.25 | 2.25 | 2.23 | 2.13 | 2.16 | 2.23 | 2.23 | 2.13 | 2.13 |
| -0.1 | 2.29 | 2.32 | 2.20 | 2.20 | 2.20 | 2.20 | 2.10 | 2.10 | 2.10 | 2.10 |
| -0.05 | 2.31 | 2.32 | 2.21 | 2.21 | 2.19 | 2.18 | 2.12 | 2.12 | 2.11 | 2.11 |
| 0 | 2.30 | 2.27 | 2.19 | 2.21 | 2.13 | 2.20 | 2.19 | 2.19 | 2.19 | 2.19 |

In Table 1 and Table 2, column 1 represents the slope in the foregoing control parameters, and column 2 to a last column in row 1 describe an average column weight of the base matrix. Each item in the tables represents an SNR value required to reach FER = $10^{-3}$ at a corresponding slope (row) and an average column weight (column). A lower SNR value indicates better performance of a corresponding code. Two typical optimal designed codes (that is, base matrices) that achieve a good balance between performance and complexity are taken below: low complexity ($\eta$ = 3.2) and high complexity ($\eta$ = 3.6) as shown by values in bold in Table 2. In this application, the base matrix of the designed LDPC code may be first obtained, and then the base matrix is extended to obtain parity check matrices of LDPC codes with different code lengths.

Code rates of parity check matrix 41, parity check matrix 42, parity check matrix 43, and parity check matrix 44 provided in this embodiment of this application are all 1/2, and code lengths thereof are respectively 320 bits, 640 bits, 1280 bits, and 2560 bits. Code rates of parity check matrix 51, parity check matrix 52, parity check matrix 53, and parity check matrix 54 provided in this embodiment of this application are all 1/2, and code lengths thereof are respectively 320 bits, 640 bits, 1280 bits, and 2560 bits. Complexity of base matrix 4 to which parity check matrix 41, parity check matrix 42, parity check matrix 43, and parity check matrix 44 conform is 3.2, and complexity of base matrix 5 to which parity check matrix 51, parity check matrix 52, parity check matrix 53, and parity check matrix 54 conform is 3.6. Complexity of the base matrix may represent complexity of performing single decoding by using the parity check matrix extended from the base matrix. It may be understood that higher complexity of the base matrix indicates higher complexity of performing single decoding by using the parity check matrix extended from the base matrix. In this application, complexity of the base matrix is complexity of an LDPC code obtained based on the base matrix.

With reference to the accompanying drawings, the following describes bit error rate (frame error rate, FER) simulation performance of LDPC codes with complexity 3.2 and complexity 3.6 respectively in different iterations of layered decoding provided in this application. The LDPC codes with 3.2 and 3.6 may be understood as a solution to performing LDPC encoding or decoding by using a base matrix provided in this application.

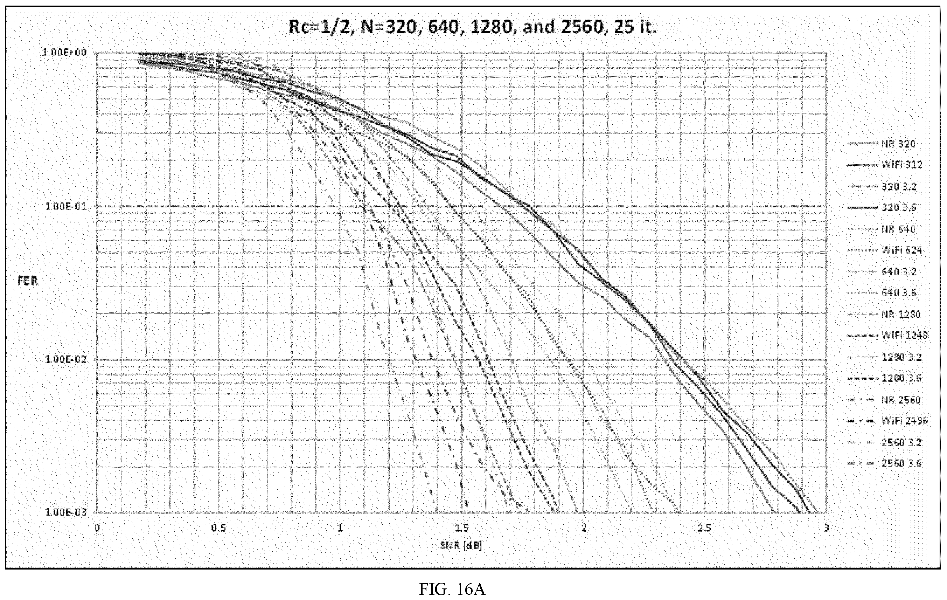

FIG. 16A is a diagram of comparison of FER simulation performance of an LDPC code in 25 iterations of layered decoding according to an embodiment of this application. Refer to FIG. 16A. A horizontal coordinate represents an SNR, and a vertical coordinate represents an FER. NR 320 represents an FER in 15 iterations of layered decoding performed based on a parity check matrix with a code rate of 1/2 and a code length of 320 bits in an NR system. Wi-Fi 312 represents an FER in 15 iterations of layered decoding performed by a Wi-Fi device (for example, a station or an access point) based on a parity check matrix with a code rate of 1/2 and a code length of 320 bits. 320 3.2 represents an FER in 15 iterations of layered decoding performed by the receive end based on an LDPC code with a code rate of 1/2, a code length of 320 bits, and complexity of 3.2. 640 3.6 represents an FER in 15 iterations of layered decoding performed by the receive end based on an LDPC code with a code rate of 1/2, a code length of 320 bits, and complexity of 3.6. NR 640 represents an FER in 15 iterations of layered decoding performed based on a parity check matrix with a code rate of 1/2 and a code length of 640 bits in an NR system. Wi-Fi 624 represents an FER in 15 iterations of layered decoding performed by a Wi-Fi device (for example, a station or an access point) based on a parity check matrix with a code rate of 1/2 and a code length of 640 bits. 640 3.2 represents an FER in 15 iterations of layered decoding performed by the receive end based on an LDPC code with a code rate of 1/2, a code length of 640 bits, and complexity of 3.2. 640 3.6 represents an FER in 15 iterations of layered decoding performed by the receive end based on an LDPC code with a code rate of 1/2, a code length of 640 bits, and complexity of 3.6. NR 1280 represents an FER in 15 iterations of layered decoding performed based on a parity check matrix with a code rate of 1/2 and a code length of 1280 bits in an NR system. Wi-Fi 1248 represents an FER in 15 iterations of layered decoding performed by a Wi-Fi device (for example, a station or an access point) based on a parity check matrix with a code rate of 1/2 and a code length of 1280 bits. 1280 3.2 represents an FER in 15 iterations of layered decoding performed by the receive end based on an LDPC code with a code rate of 1/2, a code length of 1280 bits, and complexity of 3.2. 1280 3.6 represents an FER in 15 iterations of layered decoding performed by the receive end based on an LDPC code with a code rate of 1/2, a code length of 1280 bits, and complexity of 3.6. NR 2560 represents an FER in 15 iterations of layered decoding performed based on a parity check matrix with a code rate of 1/2 and a code length of 2560 bits in an NR system. Wi-Fi 2496 represents an FER in 15 iterations of layered decoding performed by a Wi-Fi device (for example, a station or an access point) based on a parity check matrix with a code rate of 1/2 and a code length of 2560 bits. 2560 3.2 represents an FER in 15 iterations of layered decoding performed by the receive end based on an LDPC code with a code rate of 1/2, a code length of 2560 bits, and complexity of 3.2. 2560 3.6 represents an FER in 15 iterations of layered decoding performed by the receive end based on an LDPC code with a code rate of 1/2, a code length of 2560 bits, and complexity of 3.6.

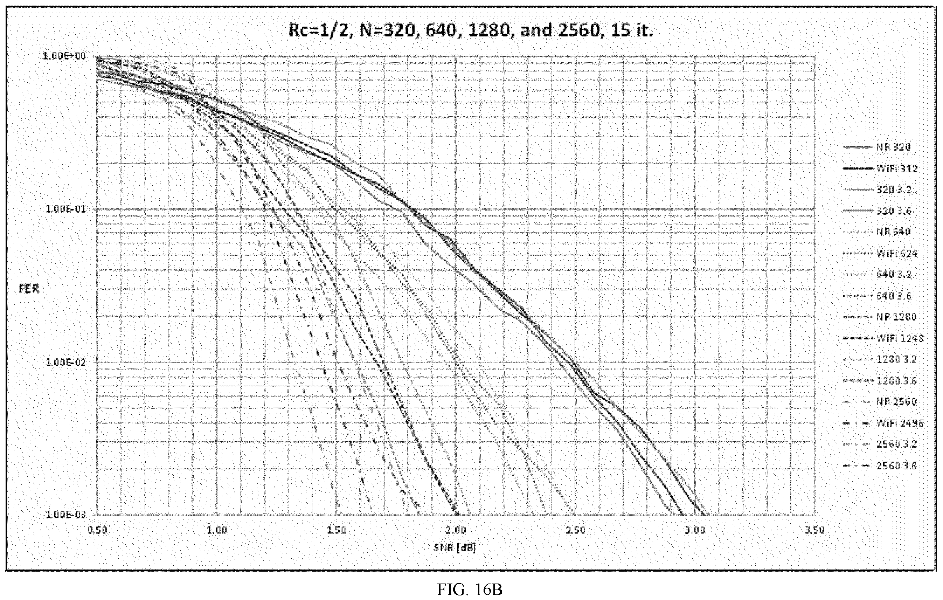

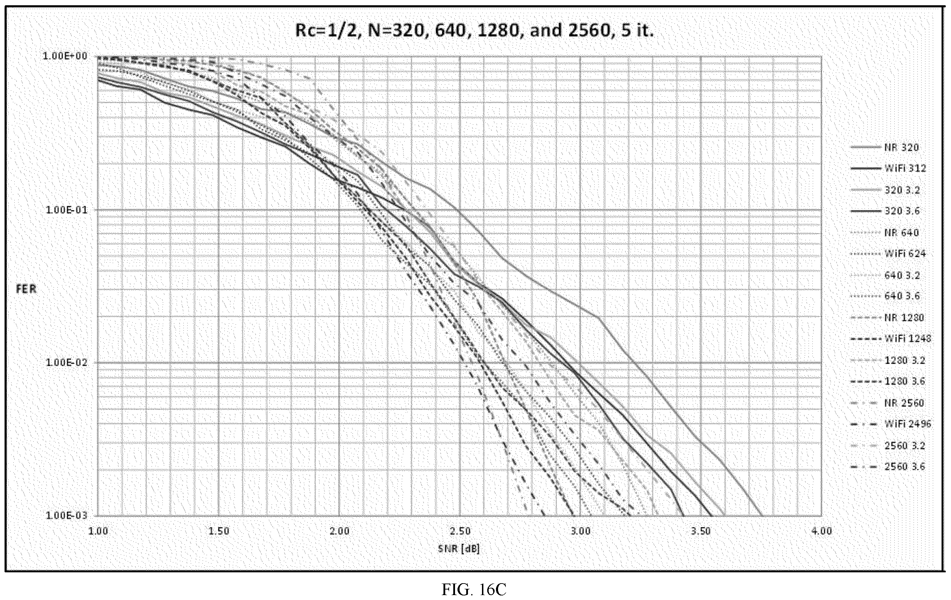

FIG. 16B is a diagram of comparison of FER simulation performance of an LDPC code in 15 iterations of layered decoding according to this application. FIG. 16C is a diagram of comparison of FER simulation performance of an LDPC code in five iterations of layered decoding according to this application. Meanings of lines in FIG. 16B and FIG. 16C are similar to meanings of lines in FIG. 16A, and details are not described herein again.

Refer to FIG. 16A, FIG. 16B, and FIG. 16C. The LDPC code designed in this application can obtain better performance when a quantity of iterations of decoding is relatively small (for example, five iterations), and can flexibly control a balance between decoding complexity and performance. Table 3, Table 4, and Table 5 respectively show comprehensive comparison of performance and complexity between the LDPC code provided in this application and the WLAN LDPC and the NR LDPC in different quantities of iterations of decoding. It can be learned that, in a case of low complexity, the LDPC code provided in this application can obtain better performance, and only a single base matrix needs to be extended.

**Table 3**

| Code (code) | Av.vardegree | Code length (blocksize) | Complexity (complexity) | SNR @1e-2 | SNR @1e-3 |
|---|---|---|---|---|---|
| Wi-Fi | 3.66 | 312 | 18.3 | 2.77 | 3.37 |
| | 3.66 | 624 | 18.3 | 2.50 | 3.01 |
| | 3.66 | 1248 | 18.3 | 2.41 | 2.80 |
| | 3.66 | 2496 | 18.3 | 2.34 | 2.68 |
| 5G NR | 3.07 | 320 | 15.4 | 3.05 | 3.58 |
| | 3.28 | 640 | 16.4 | 2.71 | 3.10 |
| | 3.40 | 1280 | 17.0 | 2.51 | 2.79 |
| | 3.50 | 2560 | 17.5 | 2.37 | 2.61 |
| New 3.2 | 3.19 | 320 | 16.0 | 2.81 | 3.42 |
| | 3.19 | 640 | 16.0 | 2.52 | 2.92 |
| | 3.19 | 1280 | 16.0 | 2.65 | 3.15 |
| | 3.19 | 2560 | 16.0 | 2.69 | 3.15 |
| New 3.6 | 3.50 | 320 | 17.5 | 2.75 | 3.25 |
| | 3.50 | 640 | 17.5 | 2.42 | 2.87 |
| | 3.50 | 1280 | 17.5 | 2.43 | 3.03 |
| | 3.50 | 2560 | 17.5 | 2.59 | 3.08 |

Table 3 shows comprehensive comparison of performance and complexity between the LDPC code provided in this application and the WLAN LDPC and the NR LDPC in five iterations of layered decoding. New 3.2 represents an LDPC code (corresponding to a base matrix provided in this application) with a code rate of 1/2, a code length of 2560 bits, and complexity of 3.2 according to this application. New 3.6 represents an LDPC code (corresponding to another base matrix provided in this application) with a code rate of 1/2, a code length of 2560 bits, and complexity of 3.6 according to this application. Column 2 represents an average variable node degree, and SNR @1e-2 represents an SNR required for five iterations of layered decoding to reach FER = $10^{-2}$. SNR @1e-2 represents an SNR required for five iterations of layered decoding to reach FER = $10^{-3}$.

**Table 4**

| Code (code) | Av.vardegree | Code length (blocksize) | Complexity (complexity) | SNR @1e-2 | SNR @1e-3 |
|---|---|---|---|---|---|
| Wi-Fi | 3.66 | 312 | 54.9 | 2.31 | 2.86 |
| | 3.66 | 624 | 54.9 | 1.85 | 2.32 |
| | 3.66 | 1248 | 54.9 | 1.49 | 1.83 |
| | 3.66 | 2496 | 54.9 | 1.26 | 1.48 |
| 5G NR | 3.07 | 320 | 46.1 | 2.26 | 2.74 |
| | 3.28 | 640 | 49.2 | 2.15 | 2.49 |
| | 3.40 | 1280 | 51.0 | 1.41 | 1.67 |
| | 3.50 | 2560 | 52.5 | 1.15 | 1.35 |
| New 3.2 | 3.19 | 320 | 47.9 | 2.32 | 2.88 |
| | 3.19 | 640 | 47.9 | 2.31 | 2.61 |
| | 3.19 | 1280 | 47.9 | 1.60 | 1.89 |
| | 3.19 | 2560 | 47.9 | 1.40 | 1.62 |
| New 3.6 | 3.50 | 320 | 52.5 | 2.29 | 2.77 |
| | 3.50 | 640 | 52.5 | 1.83 | 2.21 |
| | 3.50 | 1280 | 52.5 | 1.52 | 1.84 |
| | 3.50 | 2560 | 52.5 | 1.33 | 1.71 |

Table 4 shows comprehensive comparison of performance and complexity between the LDPC code provided in this application and the WLAN LDPC and the NR LDPC in 15 iterations of layered decoding. For meanings of the parameters in Table 4, refer to Table 3.

**Table 5**

| Code (code) | Av.vardegree | Code length (blocksize) | Complexity (complexity) | SNR @1e-2 | SNR @1e-3 |
|---|---|---|---|---|---|
| Wi-Fi | 3.66 | 312 | 91.5 | 2.23 | 2.75 |
| | 3.66 | 624 | 91.5 | 1.76 | 2.22 |
| | 3.66 | 1248 | 91.5 | 1.39 | 1.71 |
| | 3.66 | 2496 | 91.5 | 1.13 | 1.35 |
| 5G NR | 3.07 | 320 | 76.8 | 2.16 | 2.61 |
| | 3.28 | 640 | 82.0 | 1.69 | 2.03 |
| | 3.40 | 1280 | 85.0 | 1.29 | 1.56 |
| | 3.50 | 2560 | 87.5 | 1.02 | 1.22 |
| New 3.2 | 3.19 | 320 | 79.8 | 2.23 | 2.79 |
| | 3.19 | 640 | 79.8 | 1.84 | 2.21 |
| | 3.19 | 1280 | 79.8 | 1.53 | 1.80 |
| | 3.19 | 2560 | 79.8 | 1.30 | 1.52 |
| New 3.6 | 3.50 | 320 | 87.5 | 2.19 | 2.71 |
| | 3.50 | 640 | 87.5 | 1.76 | 2.12 |
| | 3.50 | 1280 | 87.5 | 1.43 | 1.73 |
| | 3.50 | 2560 | 87.5 | 1.20 | 1.61 |

Table 5 shows comprehensive comparison of performance and complexity between the LDPC code provided in this application and the WLAN LDPC and the NR LDPC in 25 iterations of layered decoding. For meanings of the parameters in Table 5, refer to Table 3.

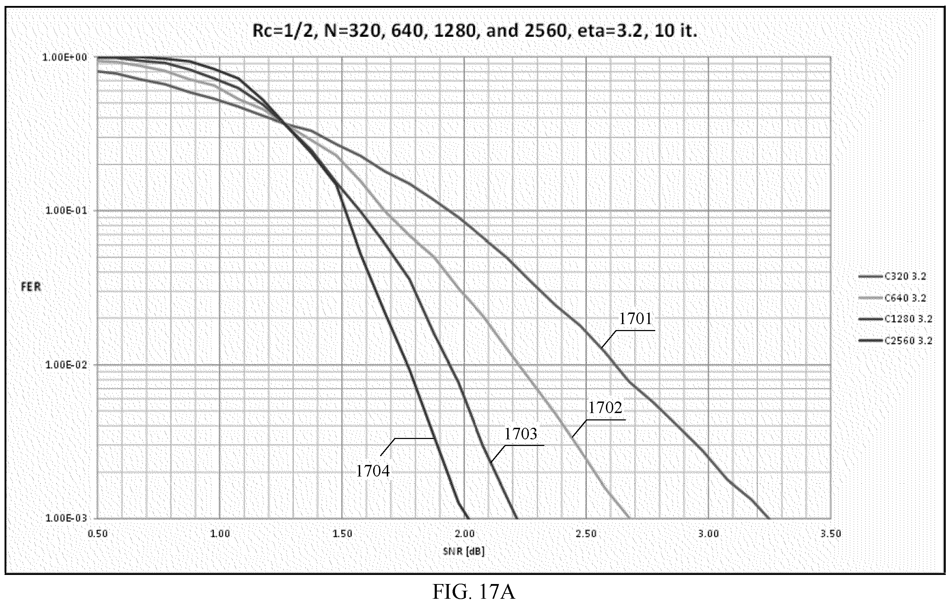

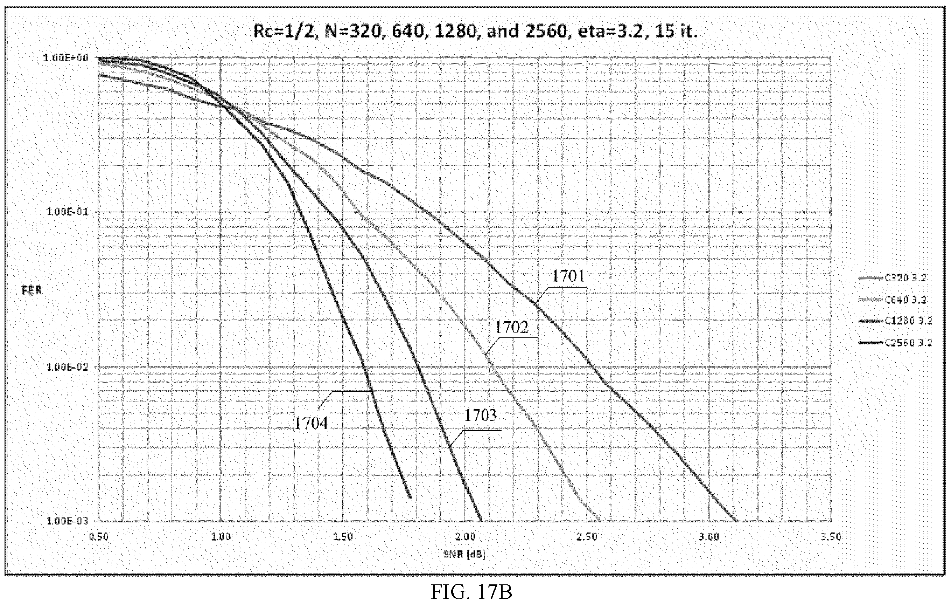

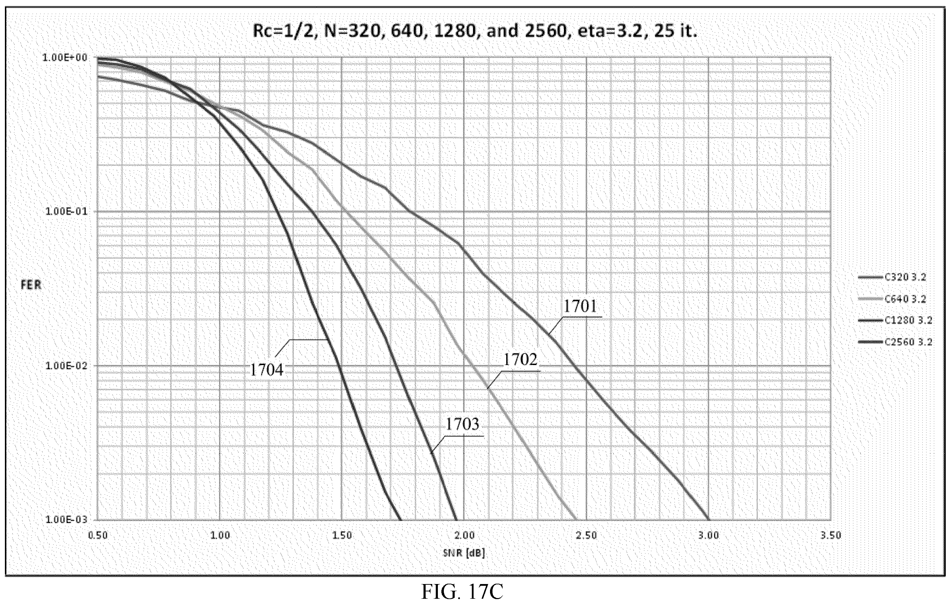

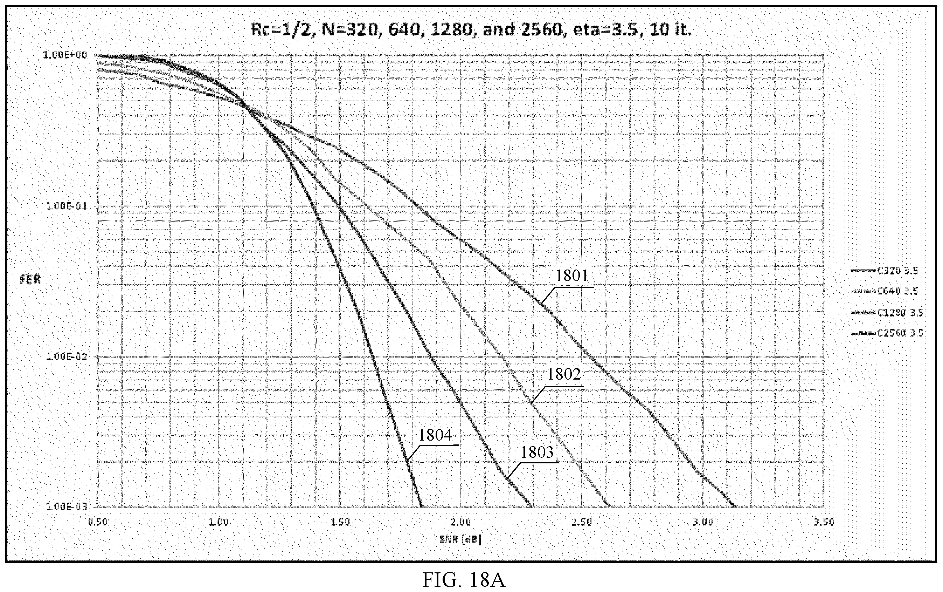

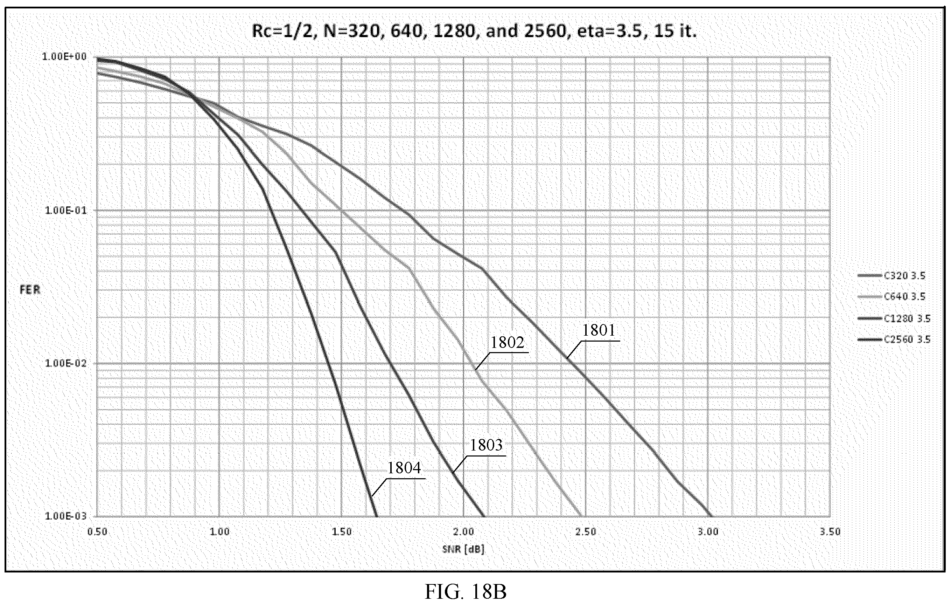

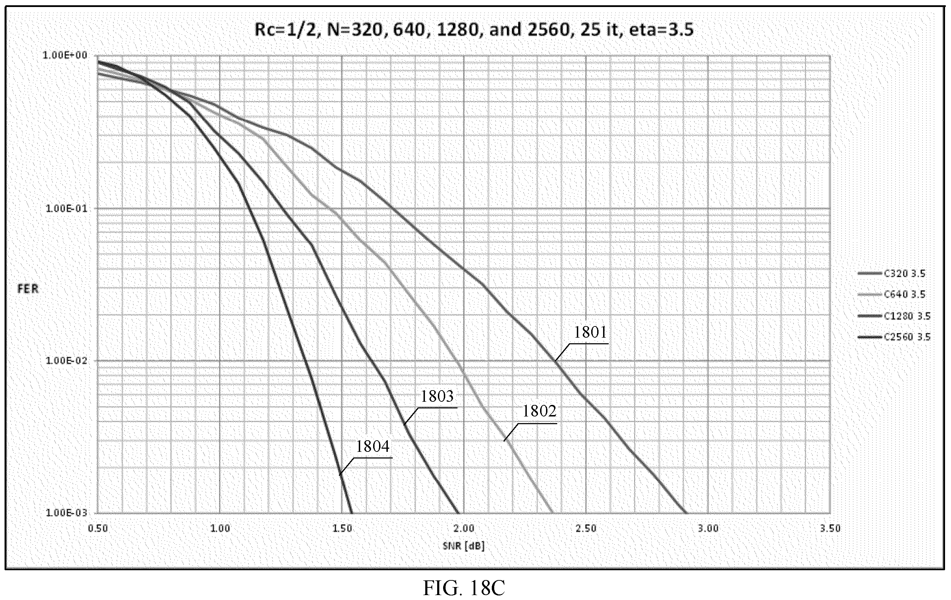

The following separately provides comparison of performance of the parity check matrix provided in this application in 10, 15, and 25 iterations of layered decoding. FIG. 17A is a diagram of performance of parity check matrix 41, parity check matrix 42, parity check matrix 43, and parity check matrix 44 in 10 iterations of decoding according to an embodiment of this application. FIG. 17B is a diagram of performance of parity check matrix 41, parity check matrix 42, parity check matrix 43, and parity check matrix 44 in 15 iterations of decoding according to an embodiment of this application. FIG. 17C is a diagram of performance of parity check matrix 41, parity check matrix 42, parity check matrix 43, and parity check matrix 44 in 25 iterations of decoding according to an embodiment of this application. In FIG. 17A, FIG. 17B, and FIG. 17C, 1701 represents a performance curve of parity check matrix 41, 1702 represents a performance curve of parity check matrix 42, 1703 represents a performance curve of parity check matrix 43, and 1704 represents a performance curve of parity check matrix 44. FIG. 18A is a diagram of performance of parity check matrix 51, parity check matrix 52, parity check matrix 53, and parity check matrix 54 in 10 iterations of decoding according to an embodiment of this application. FIG. 18B is a diagram of performance of parity check matrix 51, parity check matrix 52, parity check matrix 53, and parity check matrix 54 in 15 iterations of decoding according to an embodiment of this application. FIG. 18C is a diagram of performance of parity check matrix 51, parity check matrix 52, parity check matrix 53, and parity check matrix 54 in 25 iterations of decoding according to an embodiment of this application. In FIG. 18A, FIG. 18B, and FIG. 18C, 1801 represents a performance curve of parity check matrix 51, 1802 represents a performance curve of parity check matrix 52, 1803 represents a performance curve of parity check matrix 53, and 1804 represents a performance curve of parity check matrix 54.

It can be learned from FIG. 17A, FIG. 17B, FIG. 17C, FIG. 18A, FIG. 18B, and FIG. 18C that, in this application, excellent decoding performance can be obtained by using a single base matrix and different extension factors, and a good balance can be achieved between decoding performance and complexity.

With reference to the accompanying drawings, the following describes a structure of a communication apparatus that can implement an LDPC code encoding method or an LDPC code decoding method provided in embodiments of this application.

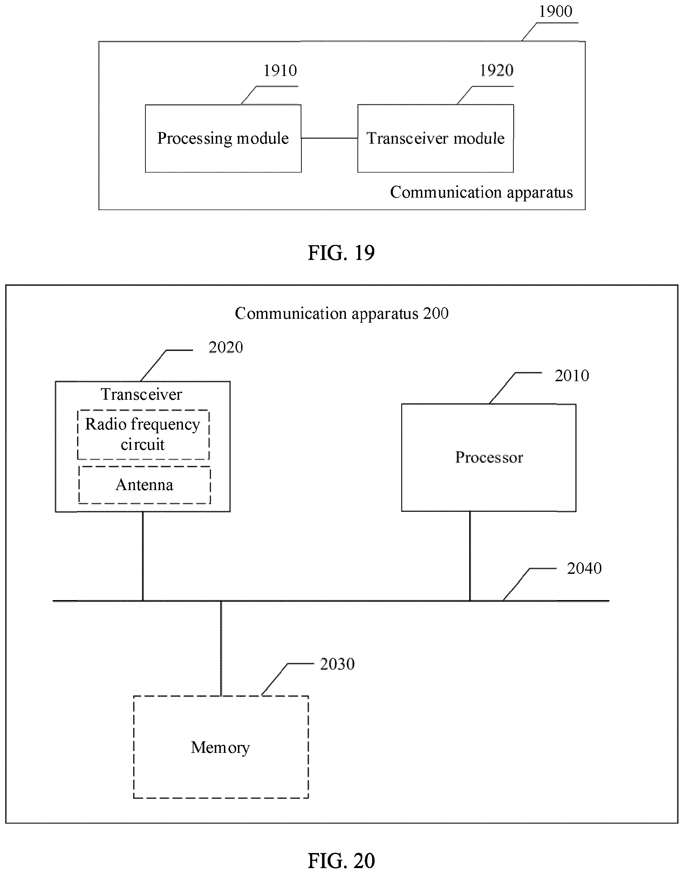

FIG. 19 is a diagram of a structure of a communication apparatus 1900 according to an embodiment of this application. The communication apparatus 1900 may correspondingly implement functions or steps implemented by the transmit end in the foregoing method embodiments, or may correspondingly implement functions or steps implemented by the receive end in the foregoing method embodiments. The communication apparatus may include a processing module 1910 and a transceiver module 1920. Optionally, the communication apparatus may further include a storage unit. The storage unit may be configured to store instructions (code or a program) and/or data. The processing module 1910 and the transceiver module 1920 may be coupled to the storage unit. For example, the processing module 1910 may read the instructions (the code or the program) and/or the data in the storage unit, to implement a corresponding method. The foregoing units may be disposed independently, or may be partially or completely integrated. For example, the transceiver module 1920 may include a sending module and a receiving module. The sending module may be a transmitter, and the receiving module may be a receiver. An entity corresponding to the transceiver module 1920 may be a transceiver, or may be a communication interface.

In some possible implementations, the communication apparatus 1900 can correspondingly implement behavior and functions of the transmit end in the foregoing method embodiments. For example, the communication apparatus 1900 may be a station, or may be a component (for example, a chip or a circuit) used in a station. For example, the communication apparatus 1900 may be an access point, or may be a component (for example, a chip or a circuit) used in an access point. For example, the transceiver module 1920 may be configured to perform all receiving or sending operations performed by the transmit end in the embodiments in FIG. 8, FIG. 9, and FIG. 10, for example, step 802 in the embodiment shown in FIG. 8, step 903 in the embodiment shown in FIG. 9, step 1003 and step 1007 in the embodiment shown in FIG. 10, and/or another process used to support the technology described in this specification. The processing module 1910 is configured to perform all operations performed by the transmit end in the embodiments shown in FIG. 8, FIG. 9, and FIG. 10 except the receiving and sending operations, for example, step 801 in the embodiment shown in FIG. 8, step 902 and step 902 in the embodiment shown in FIG. 9, and step 1001, step 1002, step 1006, and step 1007 in the embodiment shown in FIG. 10.

In some possible implementations, the communication apparatus 1900 can correspondingly implement behavior and functions of the receive end in the foregoing method embodiments. For example, the communication apparatus 1900 may be an access point, or may be a component (for example, a chip or a circuit) used in an access point. For example, the communication apparatus 1900 may be a station, or may be a component (for example, a chip or a circuit) used in a station. For example, the transceiver module 1920 may be configured to perform all receiving or sending operations performed by the receive end in the embodiments in FIG. 8, FIG. 9, and FIG. 10, for example, step 802 in the embodiment shown in FIG. 8, step 903 in the embodiment shown in FIG. 9, step 1003 and step 1008 in the embodiment shown in FIG. 10, and/or another process used to support the technology described in this specification. The processing module 1910 is configured to perform all operations performed by the receive end except the receiving and sending operations, for example, step 803 and step 804 in the embodiment shown in FIG. 8, step 904, step 905, step 906, and step 907 in the embodiment shown in FIG. 9, and step 1004, step 1005, step 1009, and step 1010 in the embodiment shown in FIG. 10.

FIG. 20 is a diagram of a structure of another communication apparatus 200 according to an embodiment of this application. The communication apparatus in FIG. 20 may be the foregoing transmit end, or may be the foregoing receive end.

As shown in FIG. 20, the communication apparatus 200 includes at least one processor 2010 and a transceiver 2020.

In some embodiments of this application, the processor 2010 and the transceiver 2020 may be configured to perform functions, operations, or the like performed by the transmit end. For example, the transceiver 2020 performs all receiving or sending operations performed by the transmit end in the embodiments in FIG. 8, FIG. 9, and FIG. 10. For example, the processor 2010 is configured to perform all operations performed by the transmit end except the sending and receiving operations in the embodiments in FIG. 8, FIG. 9, and FIG. 10.

In some embodiments of this application, the processor 2010 and the transceiver 2020 may be configured to perform functions, operations, or the like performed by the receive end. For example, the transceiver 2020 performs all receiving or sending operations performed by the receive end in the embodiments in FIG. 8, FIG. 9, and FIG. 10. The processor 2010 is configured to perform all operations performed by the receive end except the receiving and sending operations.

The transceiver 2020 is configured to communicate with another device/apparatus through a transmission medium. The processor 2010 receives and sends data and/or signaling by using the transceiver 2020, and is configured to implement the method in the foregoing method embodiments. The processor 2010 may implement a function of the processing module 1910, and the transceiver 2020 may implement a function of the transceiver module 1920.

Optionally, the transceiver 2020 may include a radio frequency circuit and an antenna. The radio frequency circuit is mainly configured to perform conversion between a baseband signal and a radio frequency signal, and process the radio frequency signal. The antenna is mainly configured to receive or send a radio frequency signal in a form of an electromagnetic wave. An input/output apparatus, for example, a touchscreen, a display, or a keyboard, is mainly configured to receive data input by a user and output data to the user.

Optionally, the communication apparatus 200 may further include at least one memory 2030, configured to store program instructions and/or data. The memory 2030 is coupled to the processor 2010. The coupling in this embodiment of this application may be an indirect coupling or a communication connection between apparatuses, units, or modules in an electrical form, a mechanical form, or another form, and is used for information exchange between the apparatuses, the units, or the modules. The processor 2010 may cooperate with the memory 2030. The processor 2010 may execute the program instructions stored in the memory 2030. At least one of the at least one memory may be included in the processor.

After the communication apparatus 200 is powered on, the processor 2010 may read the software program from the memory 2030, interpret and execute instructions of the software program, and process the data of the software program. When data needs to be sent wirelessly, the processor 2010 performs baseband processing on the to-be-sent data, and then outputs a baseband signal to the radio frequency circuit. The radio frequency circuit performs radio frequency processing on the baseband signal, and then sends the radio frequency signal in a form of an electromagnetic wave by using the antenna. When data is sent to the communication apparatus, the radio frequency circuit receives a radio frequency signal by using the antenna, converts the radio frequency signal into a baseband signal, and outputs the baseband signal to the processor 2010. The processor 2010 converts the baseband signal into data and processes the data.

In another implementation, the radio frequency circuit and the antenna may be disposed independently of the processor that performs baseband processing. For example, in a distributed scenario, the radio frequency circuit and the antenna may be remotely disposed independently of the communication apparatus.

A specific connection medium between the transceiver 2020, the processor 2010, and the memory 2030 is not limited in this embodiment of this application. In this embodiment of this application, the memory 2030, the processor 2010, and the transceiver 2020 are connected through a bus 2040 in FIG. 20. The bus is represented by using a bold line in FIG. 20. A manner of connection between other components is merely an example for description, and is not limited thereto. The bus may be classified into an address bus, a data bus, a control bus, and the like. For ease of representation, only one bold line represents the bus in FIG. 20, but this does not mean that there is only one bus or only one type of bus.

In this embodiment of this application, the processor may be a general-purpose processor, a digital signal processor, an application-specific integrated circuit, a field programmable gate array or another programmable logic device, a discrete gate or transistor logic device, or a discrete hardware component, and may implement or perform the methods, steps, and logical block diagrams disclosed in embodiments of this application. The general-purpose processor may be a microprocessor or any conventional processor or the like. The steps of the method disclosed with reference to embodiments of this application may be directly performed by a hardware processor, or may be performed by using a combination of hardware in the processor and a software module.

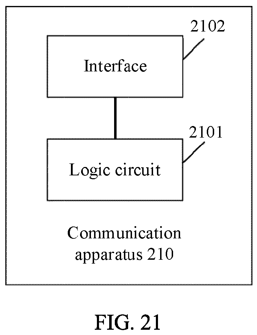

FIG. 21 is a diagram of a structure of another communication apparatus 210 according to an embodiment of this application. As shown in FIG. 21, the communication apparatus shown in FIG. 21 includes a logic circuit 2101 and an interface 2102. The processing module 1910 in FIG. 19 may be implemented by using the logic circuit 2101, and the transceiver module 1920 in FIG. 19 may be implemented by using the interface 2102. The logic circuit 2101 may be a chip, a processing circuit, an integrated circuit, a system-on-chip (system on chip, SoC), or the like. The interface 2102 may be a communication interface, an input/output interface, or the like. In this embodiment of this application, the logic circuit and the interface may be coupled to each other. A specific manner of connection between the logic circuit and the interface is not limited in this embodiment of this application.

In some embodiments of this application, the logic circuit and the interface may be configured to perform functions, operations, or the like performed by the transmit end.

In some embodiments of this application, the logic circuit and the interface may be configured to perform functions, operations, or the like performed by the receive end.

This application further provides a computer-readable storage medium. The computer-readable storage medium stores a computer program or instructions. When the computer program or the instructions run on a computer, the computer performs the method in the foregoing embodiment.

This application further provides a computer program product. The computer program product includes instructions or a computer program. When the instructions or the computer program runs on a computer, the method in the foregoing embodiment is performed.

This application further provides a communication system, including the transmit end and the receive end.

The foregoing descriptions are merely specific implementations of this application, but the protection scope of this application is not limited thereto. Any variation or replacement readily figured out by a person skilled in the art within the technical scope disclosed in this application shall fall within the protection scope of this application. Therefore, the protection scope of this application shall be subject to the protection scope of the claims.

## Claims

1. An LDPC code encoding method, comprising:

   performing low-density parity-check LDPC encoding on a first bit sequence based on a parity check matrix to obtain a first data packet, wherein the parity check matrix comprises a first parity check matrix and a second parity check matrix, both the first parity check matrix and the second parity check matrix conform to a first base matrix, and a code length of the first parity check matrix is different from a code length of the second parity check matrix; and

   sending the first data packet.

2. An LDPC code decoding method, comprising:

   obtaining a first log-likelihood ratio LLR sequence corresponding to a received first channel receive sequence; and

   decoding the first LLR sequence based on a parity check matrix, wherein the parity check matrix comprises a first parity check matrix and a second parity check matrix, both the first parity check matrix and the second parity check matrix conform to a first base matrix, and a code length of the first parity check matrix is different from a code length of the second parity check matrix.

3. The method according to claim 1 or 2, wherein a specific extension factor value of a circulant permutation matrix CPM in a first position in the first parity check matrix is b, an extension factor of the CPM in the first position in the first parity check matrix is Z1, a specific extension factor value of a CPM in a first position in the second parity check matrix is (b mod Z), and an extension factor of the CPM in the first position in the second parity check matrix is Z2, wherein Z, Z1, and Z2 are all integers greater than 0, Z1 is greater than or equal to Z, and Z2 is less than Z.

4. The method according to claim 1 or 2, wherein a specific extension factor value of a CPM in a first position in the first parity check matrix is b, an extension factor of the CPM in the first position in the first parity check matrix is Z3, a specific extension factor value of a CPM in a first position in the second parity check matrix is any one of b, (b+Z), and (b+2Z), and an extension factor of the CPM in the first position in the second parity check matrix is Z4, wherein Z, Z3, and Z4 are all integers greater than 0, Z3 is less than Z, and Z4 is greater than or equal to Z.

5. The method according to any one of claims 1 to 4, wherein the first base matrix comprises H rows or M columns of the following matrix (12×24):

```
1 0 0 0 1 1 0 0 1 0 0 1 1 1 0 0 0 0 0
0 0 0 0 0
1 1 0 0 1 0 1 1 1 0 0 0 0 1 1 0 0 0 0
0 0 0 0 0
1 0 1 0 1 0 0 0 1 0 1 0 0 0 1 1 0 0 0
0 0 0 0 0
1 0 0 1 1 0 0 0 1 1 0 0 0 0 0 0 1 1 0 0
0 0 0 0 0
1 0 0 0 1 0 0 0 1 0 1 1 0 0 0 0 1 1 0
0 0 0 0 0
1 0 1 1 1 0 1 0 1 0 0 0 0 0 0 0 0 1 1
0 0 0 0 0
1 0 0 0 1 0 0 0 1 1 0 0 1 0 0 0 0 0 1
1 0 0 0 0
1 1 0 0 1 0 1 0 1 0 0 0 0 0 0 0 0 0 0
1 1 0 0 0
1 1 0 1 1 1 0 0 1 0 0 0 0 0 0 0 0 0 0
0 1 1 0 0
1 0 0 0 1 0 0 0 1 0 1 1 0 0 1 0 0 0 0
0 0 1 1 0
1 0 1 0 1 1 1 0 1 1 0 0 0 0 0 0 0 1 0 0 0
0 0 0 1 1
1 0 0 0 1 0 0 1 1 1 0 0 1 0 0 0 0 0 0
0 0 0 0 1,
```

wherein H is an integer from 1 to 12, and M is an integer from 1 to 24.

**6.** The method according to any one of claims 1 to 4, wherein the first base matrix comprises H rows or M columns of the following matrix (12×24):

```
1 0 0 0 1 0 1 1 1 0 0 0 1 1 0 0 0 0 0
0 0 0 0 0
1 1 0 0 1 1 0 0 1 0 1 0 0 1 1 0 0 0 0
0 0 0 0 0
1 1 0 0 1 0 1 0 0 0 0 1 0 0 1 1 0 0 0
0 0 0 0 0
1 0 0 1 1 0 0 1 1 0 0 0 0 0 0 1 1 0 0
0 0 0 0 0
1 0 0 0 1 1 0 0 1 1 0 0 0 0 0 0 1 1 0
0 0 0 0 0
1 0 0 1 1 0 0 0 1 0 1 0 0 0 0 0 0 1 1
0 0 0 0 0
1 1 0 0 0 1 0 0 1 0 0 0 1 0 0 0 0 0 1
1 0 0 0 0
1 0 1 0 1 0 1 0 1 1 0 0 0 0 0 0 0 0 0
1 1 0 0 0
1 0 0 1 1 0 0 0 1 0 0 1 0 0 0 0 0 0 0
0 1 1 0 0
1 0 1 0 1 0 0 0 1 0 1 0 0 0 1 0 0 0 0
0 0 1 1 0
0 1 0 0 1 0 0 1 1 1 0 0 0 0 0 0 1 0 0 0
0 0 0 1 1
1 0 1 0 1 0 0 0 1 0 0 1 1 0 0 0 0 0 0
0 0 0 0 1,
```

wherein H is an integer from 1 to 12, and M is an integer from 1 to 24.

**7.** The method according to any one of claims 1 to 4, wherein the first base matrix comprises H rows or M columns of the following matrix (12×24):

```
1 0 0 0 1 0 1 0 1 0 1 0 1 0 1 1 0 0 0 0 0
0 0 0 0 0
1 0 1 0 1 0 0 0 1 1 0 0 0 1 1 0 0 0 0
0 0 0 0 0
1 0 0 0 1 1 0 0 1 1 0 0 0 0 1 1 0 0 0
0 0 0 0 0
1 1 0 0 1 0 0 1 1 0 0 0 0 0 1 1 0 0
0 0 0 0 0
1 0 0 1 1 0 0 1 1 0 0 0 0 0 0 0 1 1 0
```

```
0 0 0 0 0
1 0 0 0 1 0 1 0 1 0 0 1 0 0 0 0 0 1 1
0 0 0 0 0
1 1 1 0 0 0 1 0 1 0 0 0 1 0 0 0 0 0 1
1 0 0 0 0
1 0 0 0 1 1 1 0 1 0 1 0 0 0 0 0 0 0 0
1 1 0 0 0
1 0 0 0 1 1 0 0 1 0 0 1 0 0 0 0 0 0 0
0 1 1 0 0
0 1 0 1 1 0 0 0 1 1 0 0 0 0 1 0 0 0 0
0 0 1 1 0
1 1 0 1 1 0 0 0 0 0 1 0 0 0 0 1 0 0 0
0 0 0 1 1
1 0 1 0 1 0 0 1 1 0 0 1 1 0 0 0 0 0 0
0 0 0 0 1,
```

wherein H is an integer from 1 to 12, and M is an integer from 1 to 24.

**8.** The method according to any one of claims 1 to 4, wherein the first base matrix comprises L rows or F columns of a second matrix (12×32) corresponding to the following first matrix (12×7):

```
0 2 4 6 12 14 17
1 2 3 9 12 17 18
0 1 3 8 11 18 19
1 3 5 8 15 19 20
0 3 4 6 14 20 21
0 2 4 7 13 21 22
0 2 4 11 13 22 23
0 1 4 7 13 23 24
0 2 3 10 12 28 25
0 2 3 10 16 25 26
1 3 5 9 15 24 27
1 3 4 6 11 27 28
0 2 4 7 16 26 29
1 3 4 8 16 29 30
1 2 5 10 14 30 31
1 2 4 9 15 28 31,
```

wherein any element in row i of the first matrix is u, an element in row i and column (u+1) of the second matrix is 1, i and L are integers from 1 to 12, and F is an integer from 1 to 32.

**9.** The method according to claim 8, wherein the first parity check matrix comprises S rows or T columns of a fourth matrix (12×32) corresponding to the following third matrix (12×7):

```
14 6 19 10 16 24 0
14 31 36 40 78 35 0
47 38 29 52 49 47 0
40 22 79 0 25 0 0
10 33 13 72 40 59 0
45 3 18 67 6 0 0
4 1 77 9 24 56 0
29 0 6 0 0 0 0
30 1 47 46 58 58 0
0 43 0 35 64 0 0
37 22 49 69 78 26 0
72 11 31 48 2 3 0
43 46 7 79 58 53 0
22 62 71 66 26 26 0
51 0 0 0 3 0 0
26 59 7 7 7 7 0,
```

wherein an element in a second position in row j of the first matrix is p, an element in a second position in row j of the third matrix is q, an element in row j and column (p+1) of the fourth matrix is q, 0 in the fourth matrix represents an identity matrix with a size of (K×K), an element greater than 0 in the fourth matrix represents a CPM with a size of (K×K), the second position is any position, j is an integer from 1 to 12, p is an integer from 0 to 31, q is an integer from 0 to 79, K is an integer greater than 1, S is an integer from 1 to 12, and T is an integer from 1 to 32.

**10.** The method according to claim 8, wherein the first parity check matrix comprises S rows or T columns of a fourth matrix (12×32) corresponding to the following third matrix (12×7):

```
2 37 31 13 31 28 0
38 13 27 9 14 28 0
11 27 24 19 39 34 0
14 17 27 30 20 26 0
7 21 20 26 12 15 0
29 18 0 25 23 9 0
3 15 35 39 13 25 0
34 37 27 39 7 5 0
14 11 2 7 9 8 0
38 25 29 26 4 30 0
6 36 3 3 8 3 0
36 20 16 28 27 10 0
35 1 13 22 19 21 0
29 12 7 12 36 25 0
31 22 10 35 23 32 0
16 30 23 15 14 23 0,
```

wherein an element in a second position in row j of the first matrix is p, an element in a second position in row j of the third matrix is q, an element in row j and column (p+1) of the fourth matrix is q, 0 in the fourth matrix represents an identity matrix with a size of (K×K), an element greater than 0 in the fourth matrix represents a CPM with a size of (K×K), the second position is any position, j is an integer from 1 to 12, p is an integer from 0 to 31, q is an integer from 0 to 39, K is an integer greater than 1, S is an integer from 1 to 12, and T is an integer from 1 to 32.

**11.** The method according to claim 8, wherein the first parity check matrix comprises S rows or T columns of a fourth matrix (12×32) corresponding to the following third matrix (12×7):

```
0 5 13 16 12 8 0
10 13 2 19 7 12 0
6 15 12 14 5 2 0
17 1 5 1 8 10 0
9 2 10 17 1 11 0
18 11 2 1 14 3 0
13 1 13 8 13 13 0
14 13 6 4 12 8 0
2 1 13 18 9 0 0
7 2 9 4 4 13 0
17 7 10 5 11 7 0
16 5 10 11 8 4 0
10 14 1 12 13 10 0
7 2 15 17 6 7 0
4 8 6 8 14 2 0
15 0 0 1 15 16 0,
```

wherein an element in a second position in row j of the first matrix is p, an element in a second position in row j of the third matrix is q, an element in row j and column (p+1) of the fourth matrix is q, 0 in the fourth matrix represents an identity matrix with a size of (K×K), an element greater than 0 in the fourth matrix represents a CPM with a size of (K×K), the second position is any position, j is an integer from 1 to 12, p is an integer from 0 to 31, q is an integer from 0 to 19, K is an integer greater than 1, S is an integer from 1 to 12, and T is an integer from 1 to 32.

**12.** The method according to claim 8, wherein the first parity check matrix comprises S rows or T columns of a fourth matrix (12×32) corresponding to the following third matrix (12×7):

```
5 5 4 5 8 0 0
0 4 1 6 2 6 0
9 3 6 2 4 9 0
6 8 8 9 9 6 0
7 2 8 2 6 1 0
5 8 0 6 0 7 0
7 1 5 5 6 9 0
7 7 9 7 7 5 0
3 8 6 4 4 6 0
7 9 3 6 1 8 0
6 1 4 7 8 4 0
```

```
7 3 6 4 9 0 0
3 2 7 9 8 0 0
4 3 1 1 6 1 0
5 2 5 5 4 0 0
0 0 0 3 0 6 0,
```

wherein an element in a second position in row j of the first matrix is p, an element in a second position in row j of the third matrix is q, an element in row j and column (p+1) of the fourth matrix is q, 0 in the fourth matrix represents an identity matrix with a size of (K×K), an element greater than 0 in the fourth matrix represents a CPM with a size of (K×K), the second position is any position, j is an integer from 1 to 12, p is an integer from 0 to 31, q is an integer from 0 to 9, K is an integer greater than 1, S is an integer from 1 to 12, and T is an integer from 1 to 32.

**13.** The method according to any one of claims 1 to 4, wherein the first base matrix comprises L rows or F columns of a second matrix (12×32) corresponding to the following first matrix:

```
2 3 4 6 11 17
1 3 6 8 16 17 18
0 6 9 11 16 19
1 5 9 18 19 20
0 4 11 13 15 16 21
0 2 4 13 20 21 22
1 4 8 11 22 23
1 4 7 13 23 24
2 4 7 10 24 25
0 5 10 12 16 25 26
2 6 10 12 26 27
5 8 10 15 16 28
0 7 12 16 28 29
1 5 8 27 29 30
1 2 5 14 20 30 31
0 2 7 14 18 20 31,
```

wherein any element in row i of the first matrix is u, an element in row i and column (u+1) of the second matrix is 1, i and L are integers from 1 to 12, and F is an integer from 1 to 32.

**14.** The method according to claim 13, wherein the first parity check matrix comprises S rows or T columns of a fourth matrix (12×32) corresponding to the following third matrix:

```
59 32 15 49 21 0
55 57 16 2 52 26 0
12 36 12 43 9 0
73 31 33 73 16 0
43 47 40 76 44 36 0
54 7 16 34 57 41 0
24 66 36 12 26 0
78 41 21 42 43 0
5 23 71 32 14 0
38 34 7 36 64 70 0
5 44 44 63 61 0
45 53 25 40 79 0
52 55 32 59 43 0
62 69 36 38 72 0
38 73 63 45 10 45 0
45 59 43 16 39 20 0,
```

wherein an element in a second position in row j of the first matrix is p, an element in a second position in row j of the third matrix is q, an element in row j and column (p+1) of the fourth matrix is q, 0 in the fourth matrix represents an identity matrix with a size of (K×K), an element greater than 0 in the fourth matrix represents a CPM with a size of (K×K), the second position is any position, j is an integer from 1 to 12, p is an integer from 0 to 31, q is an integer from 0 to 79, K is an integer greater than 1, S is an integer from 1 to 12, and T is an integer from 1 to 32.

**15.** The method according to claim 13, wherein the first parity check matrix comprises S rows or T columns of a fourth matrix (12×32) corresponding to the following third matrix:

```
16 20 39 23 23 0
```

```
18  9  16  8  10  12  0
23  11  8  26  10  0
18  26  7  22  36  0
8  36  5  7  1  23  0
28  6  37  18  30  19  0
24  37  27  33  37  0
9  32  3  31  10  0
0  24  0  27  18  0
34  35  8  10  26  29  0
2  26  3  35  8  0
0  18  1  35  1  0
38  35  19  15  17  0
17  16  8  12  0  0
1  36  4  32  0  21  0
10  13  0  1  26  39  0,
```

wherein an element in a second position in row j of the first matrix is p, an element in a second position in row j of the third matrix is q, an element in row j and column (p+1) of the fourth matrix is q, 0 in the fourth matrix represents an identity matrix with a size of (K×K), an element greater than 0 in the fourth matrix represents a CPM with a size of (K×K), the second position is any position, j is an integer from 1 to 12, p is an integer from 0 to 31, q is an integer from 0 to 39, K is an integer greater than 1, S is an integer from 1 to 12, and T is an integer from 1 to 32.

16. The method according to claim 13, wherein the first parity check matrix comprises S rows or T columns of a fourth matrix (12×32) corresponding to the following third matrix:

```
4  10  15  6  9  0
5  9  9  10  2  16  0
11  14  0  15  17  0
18  19  7  1  2  0
13  1  12  8  1  3  0
8  10  19  10  4  13  0
10  12  6  2  1  0
19  6  0  4  8  0
8  6  15  1  10  0
17  6  16  15  19  7  0
19  17  19  14  9  0
11  18  14  6  18  0
16  4  0  10  19  0
14  16  13  8  4  0
3  3  8  0  3  18  0
3  11  6  7  16  6  0,
```

wherein an element in a second position in row j of the first matrix is p, an element in a second position in row j of the third matrix is q, an element in row j and column (p+1) of the fourth matrix is q, 0 in the fourth matrix represents an identity matrix with a size of (K×K), an element greater than 0 in the fourth matrix represents a CPM with a size of (K×K), the second position is any position, j is an integer from 1 to 12, p is an integer from 0 to 31, q is an integer from 0 to 19, K is an integer greater than 1, S is an integer from 1 to 12, and T is an integer from 1 to 32.

17. The method according to claim 13, wherein the first parity check matrix comprises S rows or T columns of a fourth matrix (12×32) corresponding to the following third matrix:

```
9  4  7  5  2  0
5  2  1  6  6  4  0
6  7  8  7  4  0
7  5  0  3  0  0
4  7  9  6  1  8  0
5  7  3  6  4  7  0
8  8  1  8  1  0
8  1  9  7  1  0
9  6  1  2  4  0
6  6  8  2  9  0  0
3  6  8  4  5  0
7  9  3  0  8  0
2  2  1  4  4  0
8  7  0  9  3  0
6  5  9  8  8  5  0
```

4 8 3 9 8 6 0,

wherein an element in a second position in row j of the first matrix is p, an element in a second position in row j of the third matrix is q, an element in row j and column (p+1) of the fourth matrix is q, 0 in the fourth matrix represents an identity matrix with a size of (K×K), an element greater than 0 in the fourth matrix represents a CPM with a size of (K×K), the second position is any position, j is an integer from 1 to 12, p is an integer from 0 to 31, q is an integer from 0 to 9, K is an integer greater than 1, S is an integer from 1 to 12, and T is an integer from 1 to 32.

18. A communication apparatus, comprising a module or a unit configured to implement the method according to any one of claims 1 to 17.

19. A computer-readable storage medium, wherein the computer-readable storage medium stores a computer program, the computer program comprises program instructions, and when the program instructions are executed, a computer is enabled to perform the method according to any one of claims 1 to 17.

20. A communication apparatus, comprising a processor, wherein the processor is coupled to a memory, the memory stores instructions, and the processor is configured to execute the instructions, so that the communication apparatus performs the method according to any one of claims 1 to 17.

21. A chip system, comprising a processor, configured to invoke a computer program from a memory and run the computer program, to enable a communication device on which the chip system is installed to perform the method according to any one of claims 1 to 17.

22. A computer program product, wherein when the computer program product is run on a computer, the computer is enabled to perform the method according to any one of claims 1 to 17.

$$
H = \begin{array}{c c c c c c c c}
 & V_1 & V_2 & V_3 & V_4 & V_5 & V_6 & V_7 & V_8 \\
\left[\begin{array}{c c c c c c c c}
1 & 0 & 1 & 0 & 1 & 0 & 1 & 0 \\
1 & 0 & 0 & 1 & 0 & 1 & 0 & 1 \\
0 & 1 & 1 & 0 & 0 & 1 & 1 & 0 \\
0 & 1 & 0 & 1 & 1 & 0 & 0 & 1
\end{array}\right] & 
\begin{array}{c}
C_1 \\
C_2 \\
C_3 \\
C_4
\end{array}
\end{array}
$$

FIG. 1

FIG. 2

Parity check matrix H $\xrightarrow{\text{Gaussian elimination}}$ [I P]

$\big\downarrow G \cdot H^T = 0$

Generator matrix $G = [-P^T \ I]$ $\xrightarrow{x = c \cdot G}$ Transmit codeword x

FIG. 3

401

| Payload bits (to-be-encoded data bits) |
|---|

402

Step 1

| LDPC codeword (LDPC codeword) | LDPC codeword (LDPC codeword) | ... | LDPC codeword (LDPC codeword) |
|---|---|---|---|

403

Step 2

| Payload bits | Shortening zero bits (shortening zero bits) | | Payload bits | Shortening zero bits (shortening zero bits) | | Payload bits | Shortening zero bits (shortening zero bits) | |
|---|---|---|---|---|---|---|---|---|

404

Step 3

| Payload bits | Shortening zero bits (shortening zero bits) | Parity bit | Payload bits | Shortening zero bits (shortening zero bits) | Parity bit | Payload bits | Shortening zero bits (shortening zero bits) | Parity bit |
|---|---|---|---|---|---|---|---|---|

405

Delete shortening zero bits

| Payload bits | Shortening zero bits (shortening zero bits) | Payload bits | Shortening zero bits (shortening zero bits) | Payload bits | Shortening zero bits (shortening zero bits) |
|---|---|---|---|---|---|

FIG. 4

$$
p_0 = \begin{bmatrix} 1 & 0 & 0 & 0 \\ 0 & 1 & 0 & 0 \\ 0 & 0 & 1 & 0 \\ 0 & 0 & 0 & 1 \end{bmatrix} \quad
p_1 = \begin{bmatrix} 0 & 1 & 0 & 0 \\ 0 & 0 & 1 & 0 \\ 0 & 0 & 0 & 1 \\ 1 & 0 & 0 & 0 \end{bmatrix} \quad
p_2 = \begin{bmatrix} 0 & 0 & 1 & 0 \\ 0 & 0 & 0 & 1 \\ 1 & 0 & 0 & 0 \\ 0 & 1 & 0 & 0 \end{bmatrix} \quad
p_3 = \begin{bmatrix} 0 & 0 & 0 & 1 \\ 1 & 0 & 0 & 0 \\ 0 & 1 & 0 & 0 \\ 0 & 0 & 1 & 0 \end{bmatrix}
$$

FIG. 5

```
 0  -  -  -  0  0  -  -  0  -  -  0  1  0  -  -  -  -  -  -  -  -  -  -
22  0  -  - 17  -  0  0 12  -  -  -  -  0  0  -  -  -  -  -  -  -  -  -
 6  -  0  - 10  -  -  - 24  -  0  -  -  -  0  0  -  -  -  -  -  -  -  -
 2  -  -  0 20  -  -  - 25  0  -  -  -  -  0  0  -  -  -  -  -  -  -  -
23  -  -  -  3  -  -  -  0  -  9 11  -  -  -  -  0  0  -  -  -  -  -  -
24  - 23  1 17  -  3  - 10  -  -  -  -  -  -  -  -  0  0  -  -  -  -  -
25  -  -  -  8  -  -  -  7 18  -  -  0  -  -  -  -  -  0  0  -  -  -  -
13 24  -  -  0  -  8  -  6  -  -  -  -  -  -  -  -  -  -  0  0  -  -  -
 7 20  - 16 22 10  -  - 23  -  -  -  -  -  -  -  -  -  -  -  0  0  -  -
11  -  -  - 19  -  -  - 13  -  3 17  -  -  -  -  -  -  -  -  -  0  0  -
25  -  8  - 23 18  - 14  9  -  -  -  -  -  -  -  -  -  -  -  -  -  0  0
 3  -  -  - 16  -  -  2 25  5  -  -  1  -  -  -  -  -  -  -  -  -  -  0
```

FIG. 6

((o))

AP

STA 1                STA 2

FIG. 7

Transmit end

Receive end

801

The transmit end performs LDPC encoding on a first bit sequence based on a parity check matrix to obtain a first data packet

First data packet    802

803

Determine a first LLR sequence corresponding to a first channel receive sequence, and decode the first LLR sequence based on the parity check matrix to obtain a first decoding result

804

If decoding succeeds, output the first decoding result

FIG. 8

Transmit end

Receive end

901

Perform LDPC encoding on a first bit sequence based on a first parity check matrix to obtain a first data packet

902

Perform LDPC encoding on a second bit sequence based on a second parity check matrix to obtain a second data packet

First data packet and second data packet

903

904

Determine a first LLR sequence corresponding to a first channel receive sequence, and decode the first LLR sequence based on the first parity check matrix to obtain a first decoding result

905

If decoding succeeds, output the first decoding result

906

Determine a second LLR sequence corresponding to a second channel receive sequence, and decode the second LLR sequence based on the second parity check matrix to obtain a second decoding result

907

If decoding succeeds, output the second decoding result

FIG. 9

```
         ┌──────────────┐                              ┌──────────────┐
         │ Transmit end │                              │  Receive end │
         └──────┬───────┘                              └──────┬───────┘
                │                                             │
┌───────────────────────────────────────────┐ 1001           │
│ When a length of a to-be-encoded first bit │                │
│ sequence is within a first interval, obtain│                │
│ a first parity check matrix by extending a │                │
│ first base matrix                          │                │
└───────────────────────────────────────────┘                │
                │                                             │
  ┌─────────────────────────────────────────┐ 1002           │
  │ Perform LDPC encoding on the first bit    │               │
  │ sequence based on the first parity check  │               │
  │ matrix to obtain a first data packet      │               │
  └─────────────────────────────────────────┘                │
                │                                             │
                │     First data packet    1003               │
                │────────────────────────────────────────────▶│
                │                                             │  1004
                │         ┌───────────────────────────────────────────────┐
                │         │ Determine a first LLR sequence corresponding   │
                │         │ to a first channel receive sequence, and decode│
                │         │ the first LLR sequence based on the first      │
                │         │ parity check matrix to obtain a first decoding │
                │         │ result                                         │
                │         └───────────────────────────────────────────────┘
                │                                             │  1005
                │             ┌───────────────────────────────────────┐
                │             ┆ If decoding succeeds, output the        ┆
                │             ┆ first decoding result                   ┆
                │             └───────────────────────────────────────┘
                │                                             │
┌───────────────────────────────────────────┐ 1006           │
│ When a length of a to-be-encoded second bit│                │
│ sequence is within a second interval, obtain│               │
│ a second parity check matrix by extending  │                │
│ the first base matrix                      │                │
└───────────────────────────────────────────┘                │
                │                                             │
  ┌─────────────────────────────────────────┐ 1007           │
  │ Perform LDPC encoding on the second bit   │               │
  │ sequence based on the second parity check │               │
  │ matrix to obtain a second data packet     │               │
  └─────────────────────────────────────────┘                │
                │                                             │
                │    Second data packet    1008               │
                │────────────────────────────────────────────▶│
                │                                             │  1009
                │         ┌───────────────────────────────────────────────┐
                │         │ Determine a second LLR sequence corresponding  │
                │         │ to a second channel receive sequence, and      │
                │         │ decode the second LLR sequence based on the    │
                │         │ second parity check matrix to obtain a second  │
                │         │ decoding result                                │
                │         └───────────────────────────────────────────────┘
                │                                             │  1010
                │             ┌───────────────────────────────────────┐
                │             ┆ If decoding succeeds, output the        ┆
                │             ┆ second decoding result                  ┆
                │             └───────────────────────────────────────┘
```

FIG. 10

| Mother Matrix | | | | | | | N=2560, Z=80 | | | | | | | N=1280, Z=40 | | | | | | | N=640, Z=20 | | | | | | | N=320, Z=10 | | | | | | |
|---|---|---|---|---|---|---|---|---|---|---|---|---|---|---|---|---|---|---|---|---|---|---|---|---|---|---|---|---|---|---|---|---|---|---|---|
| 0 | 2 | 4 | 6 | 12 | 14 | 17 | 14 | 6 | 19 | 10 | 16 | 24 | 0 | 2 | 37 | 31 | 13 | 31 | 28 | 0 | 0 | 5 | 13 | 16 | 12 | 8 | 0 | 5 | 5 | 4 | 5 | 8 | 0 | 0 |
| 1 | 2 | 3 | 9 | 12 | 17 | 18 | 14 | 31 | 36 | 40 | 78 | 35 | 0 | 38 | 13 | 27 | 9 | 14 | 28 | 0 | 10 | 13 | 2 | 19 | 7 | 12 | 0 | 0 | 4 | 1 | 6 | 2 | 6 | 0 |
| 0 | 1 | 3 | 8 | 11 | 18 | 19 | 47 | 38 | 29 | 52 | 49 | 47 | 0 | 11 | 27 | 24 | 19 | 39 | 34 | 0 | 6 | 15 | 12 | 14 | 5 | 2 | 0 | 9 | 3 | 6 | 2 | 4 | 9 | 0 |
| 1 | 3 | 5 | 8 | 15 | 19 | 20 | 40 | 22 | 79 | 0 | 25 | 0 | 0 | 14 | 17 | 27 | 30 | 20 | 26 | 0 | 17 | 1 | 5 | 1 | 8 | 10 | 0 | 6 | 8 | 8 | 9 | 9 | 6 | 0 |
| 0 | 3 | 4 | 6 | 14 | 20 | 21 | 10 | 33 | 13 | 72 | 40 | 59 | 0 | 7 | 21 | 20 | 26 | 12 | 15 | 0 | 9 | 2 | 10 | 17 | 1 | 11 | 0 | 7 | 2 | 8 | 2 | 6 | 1 | 0 |
| 0 | 2 | 4 | 7 | 13 | 21 | 22 | 45 | 3 | 18 | 67 | 6 | 0 | 0 | 29 | 18 | 0 | 25 | 23 | 9 | 0 | 18 | 11 | 2 | 1 | 14 | 3 | 0 | 5 | 8 | 0 | 6 | 0 | 7 | 0 |
| 0 | 2 | 4 | 11 | 13 | 22 | 23 | 4 | 1 | 77 | 9 | 24 | 56 | 0 | 3 | 15 | 35 | 39 | 13 | 25 | 0 | 13 | 1 | 13 | 8 | 13 | 13 | 0 | 7 | 1 | 5 | 5 | 6 | 9 | 0 |
| 0 | 1 | 4 | 7 | 13 | 23 | 24 | 29 | 0 | 6 | 0 | 0 | 0 | 0 | 34 | 37 | 27 | 39 | 7 | 5 | 0 | 14 | 13 | 6 | 4 | 12 | 8 | 0 | 7 | 7 | 9 | 7 | 7 | 5 | 0 |
| 0 | 2 | 3 | 10 | 12 | 18 | 25 | 30 | 1 | 47 | 46 | 58 | 58 | 0 | 14 | 11 | 2 | 7 | 9 | 8 | 0 | 2 | 1 | 13 | 18 | 9 | 0 | 0 | 3 | 8 | 6 | 4 | 4 | 6 | 0 |
| 0 | 2 | 3 | 10 | 16 | 25 | 26 | 0 | 43 | 0 | 35 | 64 | 0 | 0 | 38 | 25 | 29 | 26 | 4 | 30 | 0 | 7 | 2 | 9 | 4 | 4 | 13 | 0 | 7 | 9 | 3 | 6 | 1 | 8 | 0 |
| 1 | 3 | 5 | 9 | 15 | 24 | 27 | 37 | 22 | 49 | 69 | 78 | 26 | 0 | 6 | 36 | 3 | 3 | 8 | 3 | 0 | 17 | 7 | 10 | 5 | 11 | 7 | 0 | 6 | 1 | 4 | 7 | 8 | 4 | 0 |
| 1 | 3 | 4 | 6 | 11 | 27 | 28 | 72 | 11 | 31 | 48 | 2 | 3 | 0 | 36 | 20 | 16 | 28 | 27 | 10 | 0 | 16 | 5 | 10 | 11 | 8 | 4 | 0 | 7 | 3 | 6 | 4 | 9 | 0 | 0 |
| 0 | 2 | 4 | 7 | 16 | 26 | 29 | 43 | 46 | 7 | 79 | 58 | 53 | 0 | 35 | 1 | 13 | 22 | 19 | 21 | 0 | 10 | 14 | 1 | 12 | 13 | 10 | 0 | 3 | 2 | 7 | 9 | 8 | 0 | 0 |
| 1 | 3 | 4 | 8 | 16 | 29 | 30 | 22 | 62 | 71 | 66 | 26 | 26 | 0 | 29 | 12 | 7 | 12 | 36 | 25 | 0 | 7 | 2 | 15 | 17 | 6 | 7 | 0 | 4 | 3 | 1 | 1 | 6 | 1 | 0 |
| 1 | 2 | 5 | 10 | 14 | 30 | 31 | 51 | 0 | 0 | 0 | 3 | 0 | 0 | 31 | 22 | 10 | 35 | 23 | 32 | 0 | 4 | 8 | 6 | 8 | 14 | 2 | 0 | 5 | 2 | 5 | 5 | 4 | 0 | 0 |
| 1 | 2 | 4 | 9 | 15 | 28 | 31 | 26 | 59 | 7 | 7 | 7 | 7 | 0 | 16 | 30 | 23 | 15 | 14 | 23 | 0 | 15 | 0 | 0 | 1 | 15 | 16 | 0 | 0 | 0 | 0 | 3 | 0 | 6 | 0 |

FIG. 11

| | | 0 | 1 | 2 | 3 | 4 | 5 | 6 | 7 | 8 | 9 | 10 | 11 | 12 | 13 | 14 | 15 | 16 | 17 | 18 | 19 | 20 | 21 | 22 | 23 | 24 | 25 | 26 | 27 | 28 | 29 | 30 | 31 |
|---|---|---|---|---|---|---|---|---|---|---|---|---|---|---|---|---|---|---|---|---|---|---|---|---|---|---|---|---|---|---|---|---|---|
| | | 9 | 9 | 9 | 9 | 9 | 3 | 3 | 3 | 3 | 3 | 3 | 3 | 3 | 3 | 3 | 3 | 3 | 2 | 3 | 2 | 2 | 2 | 2 | 2 | 2 | 2 | 2 | 2 | 2 | 2 | 2 | 2 |
| 0 | 7 | 5 | | 5 | | 4 | | 5 | | | | | | 8 | | 0 | | 0 | | | | | | | | | | | | | | | | |
| 1 | 7 | | 0 | 4 | 1 | | | | | 6 | | | | 2 | | | | 6 | 0 | | | | | | | | | | | | | | |
| 2 | 7 | 9 | 3 | | 6 | | | 2 | | | 4 | | | | | | | 9 | 0 | | | | | | | | | | | | | | |
| 3 | 7 | | 6 | | 8 | | 8 | | 9 | | | | | | | | 9 | | 6 | 0 | | | | | | | | | | | | | |
| 4 | 7 | 7 | | | 2 | 8 | | 2 | | | | | | 6 | | | | | | 1 | 0 | | | | | | | | | | | | |
| 5 | 7 | 5 | | 8 | | 0 | | | 6 | | | 0 | | | | | | | | | 7 | 0 | | | | | | | | | | | |
| 6 | 7 | 7 | | 1 | | 5 | | | | | 5 | | 6 | | | | | | | | | 9 | 0 | | | | | | | | | | |
| 7 | 7 | 7 | 7 | | | 9 | | | 7 | | | | | 7 | | | | | | | | | 5 | 0 | | | | | | | | | |
| 8 | 7 | 3 | | 8 | 6 | | | | | | 4 | | 4 | | | | | | 6 | | | | | | 0 | | | | | | | | |
| 9 | 7 | 7 | | 9 | 3 | | | | | | 6 | | | | | | | 1 | | | | | | 8 | 0 | | | | | | | | |
| 10 | 7 | | 6 | | 1 | | 4 | | | 7 | | | | | | | 8 | | | | | | | | | 4 | | 0 | | | | | |
| 11 | 7 | | 7 | | 3 | 6 | | 4 | | | | | 9 | | | | | | | | | | | | | | | 0 | 0 | | | | |
| 12 | 7 | 3 | | 2 | | 7 | | | 9 | | | | | | | | | 8 | | | | | | | | | 0 | | 0 | | | | |
| 13 | 7 | | 4 | | 3 | 1 | | | | 1 | | | | | | | | 6 | | | | | | | | | | | | | 1 | 0 | |
| 14 | 7 | | 5 | 2 | | | 5 | | | | | 5 | | | | 4 | | | | | | | | | | | | | | | | 0 | 0 |
| 15 | 7 | | 0 | 0 | | 0 | | | | 3 | | | | | | | 0 | | | | | | | | | | | | | | 6 | | 0 |

FIG. 12

44

| Mother Matrix | N=2560, Z=80 | N=1280, Z=40 | N=640, Z=20 | N=320, Z=10 |
|---|---|---|---|---|
| 2 3 4 6 11 17 | 59 32 15 49 21 0 | 16 20 39 23 23 0 | 4 10 15 6 9 0 | 9 4 7 5 2 0 |
| 1 3 6 8 16 17 18 | 55 57 16 2 52 26 0 | 18 9 16 8 10 12 0 | 5 9 9 10 2 16 0 | 5 2 1 6 6 4 0 |
| 0 6 9 11 16 19 | 12 36 12 43 9 0 | 23 11 8 26 10 0 | 11 14 0 15 17 0 | 6 7 8 7 4 0 |
| 1 5 9 18 19 20 | 73 31 33 73 16 0 | 18 26 7 22 36 0 | 18 19 7 1 2 0 | 7 5 0 3 0 0 |
| 0 4 11 13 15 16 21 | 43 47 40 76 44 36 0 | 8 36 5 7 1 23 0 | 13 1 12 8 1 3 0 | 4 7 9 6 1 8 0 |
| 0 2 4 13 20 21 22 | 54 7 16 34 57 41 0 | 28 6 37 18 30 19 0 | 8 10 19 10 4 13 0 | 5 7 3 6 4 7 0 |
| 1 4 8 11 22 23 | 24 66 36 12 26 0 | 24 37 27 33 37 0 | 10 12 6 2 1 0 | 8 8 1 8 1 0 |
| 1 4 7 13 23 24 | 78 41 21 42 43 0 | 9 32 3 31 10 0 | 19 6 0 4 8 0 | 8 1 9 7 1 0 |
| 2 4 7 10 24 25 | 5 23 71 32 14 0 | 0 24 0 27 18 0 | 8 6 15 1 10 0 | 9 6 1 2 4 0 |
| 0 5 10 12 16 25 26 | 38 34 7 36 64 70 0 | 34 35 8 10 26 29 0 | 17 6 16 15 19 7 0 | 6 6 8 2 9 0 0 |
| 2 6 10 12 26 27 | 5 44 44 63 61 0 | 2 26 3 35 8 0 | 19 17 19 14 9 0 | 3 6 8 4 5 0 |
| 5 8 10 15 16 28 | 45 53 25 40 79 0 | 0 18 1 35 1 0 | 11 18 14 6 18 0 | 7 9 3 0 8 0 |
| 0 7 12 16 28 29 | 52 55 32 59 43 0 | 38 35 19 15 17 0 | 16 4 0 10 19 0 | 2 2 1 4 4 0 |
| 1 5 8 27 29 30 | 62 69 36 38 72 0 | 17 16 8 12 0 0 | 14 16 13 8 4 0 | 8 7 0 9 3 0 |
| 1 2 5 14 20 30 31 | 38 73 63 45 10 45 0 | 1 36 4 32 0 21 0 | 3 3 8 0 3 18 0 | 6 5 9 8 8 5 0 |
| 0 2 7 14 18 20 31 | 45 59 43 16 39 20 0 | 10 13 0 1 26 39 0 | 3 11 6 7 16 6 0 | 4 8 3 9 8 6 0 |

## FIG. 13

## FIG. 14

## FIG. 15

FIG. 16A

FIG. 16B

FIG. 16C

Rc=1/2, N=320, 640, 1280, and 2560, eta=3.2, 10 it.

FIG. 17A

Rc=1/2, N=320, 640, 1280, and 2560, eta=3.2, 15 it.

FIG. 17B

FIG. 17C

EP 4 531 286 A1

FIG. 18A

FIG. 18B

Rc=1/2, N=320, 640, 1280, and 2560, 25 it, eta=3.5

FIG. 18C

1900

1910                          1920

| Processing module | Transceiver module |

Communication apparatus

FIG. 19

Communication apparatus 200

2020

Transceiver

2010

Radio frequency
circuit

Processor

Antenna

2040

2030

Memory

FIG. 20

2102

Interface

2101

Logic circuit

Communication
apparatus 210

FIG. 21

# EP 4 531 286 A1

| | INTERNATIONAL SEARCH REPORT | International application No. |
|---|---|---|
| | | **PCT/CN2023/100206** |

**A. CLASSIFICATION OF SUBJECT MATTER**

H03M13/11(2006.01)i

According to International Patent Classification (IPC) or to both national classification and IPC

**B. FIELDS SEARCHED**

Minimum documentation searched (classification system followed by classification symbols)

IPC: H03M

Documentation searched other than minimum documentation to the extent that such documents are included in the fields searched

Electronic data base consulted during the international search (name of data base and, where practicable, search terms used)

VEN, CNABS, CNTXT, WOTXT, USTXT, CNKI, 3GPP: 低密度奇偶校验编码, 对数似然比, 校验矩阵, 码长, 基矩阵, 基础矩阵, 基本矩阵, 循环移位矩阵, LDPC, LLR, check matrix, basic matrix, code length, CPM

**C. DOCUMENTS CONSIDERED TO BE RELEVANT**

| Category* | Citation of document, with indication, where appropriate, of the relevant passages | Relevant to claim No. |
|---|---|---|
| X | CN 113078911 A (HUAWEI TECHNOLOGIES CO., LTD.) 06 July 2021 (2021-07-06) description, paragraphs 0069 and 0216-0321 | 1-22 |
| A | CN 112751571 A (HUAWEI TECHNOLOGIES CO., LTD.) 04 May 2021 (2021-05-04) entire document | 1-22 |
| A | CN 113612486 A (CHONGQING UNIVERSITY) 05 November 2021 (2021-11-05) entire document | 1-22 |
| A | US 2011138260 A1 (COMMISSARIAT ENERGIE ATOMIQUE) 09 June 2011 (2011-06-09) entire document | 1-22 |
| A | ZTE et al. "Further consideration on compact LDPC design for eMBB" *3GPP TSG RAN WG1 Meeting #88 R1- 1701600,* 17 February 2017 (2017-02-17), entire document | 1-22 |

☐ Further documents are listed in the continuation of Box C. ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **11 July 2023** | **20 July 2023** |

| Name and mailing address of the ISA/CN | Authorized officer |
|---|---|
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2023/100206**

| Patent document cited in search report | | | Publication date (day/month/year) | Patent family member(s) | | | Publication date (day/month/year) |
|---|---|---|---|---|---|---|---|
| CN | 113078911 | A | 06 July 2021 | WO | 2021136540 | A1 | 08 July 2021 |
| | | | | EP | 4072024 | A1 | 12 October 2022 |
| | | | | US | 2022352904A1 | A1 | 03 November 2022 |
| CN | 112751571 | A | 04 May 2021 | WO | 2021083365 | A1 | 06 May 2021 |
| | | | | BR | 112022008049 | A2 | 12 July 2022 |
| | | | | VN | 88228 | A | 25 July 2022 |
| | | | | EP | 4037221 | A1 | 03 August 2022 |
| | | | | US | 2022255564 | A1 | 11 August 2022 |
| | | | | IN | 202237024995 | A | 02 September 2022 |
| CN | 113612486 | A | 05 November 2021 | US | 2023087247 | A1 | 23 March 2023 |
| US | 2011138260 | A1 | 09 June 2011 | EP | 2341628 | A2 | 06 July 2011 |
| | | | | FR | 2953666 | A1 | 10 June 2011 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202210688993

**Non-patent literature cited in the description**

- **G. MONTORSI**. Design of LDPC codes with tunable slope of their EXIT charts,'' in Turbo Codes and Iterative Information Processing (ISTC). *2016 9th International Symposium on. IEEE*, 2016, 126-130